(19) Europäisches Patentamt
European Patent Office
Office européen des brevets

(11) EP 1 467 215 A2

(12) EUROPEAN PATENT APPLICATION

(43) Date of publication:
**13.10.2004 Bulletin 2004/42**

(51) Int Cl.⁷: **G01R 31/40**

(21) Application number: **04101466.3**

(22) Date of filing: **08.04.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL LT LV MK**

(30) Priority: **09.04.2003 JP 2003105718**
**30.04.2003 JP 2003124616**
**20.06.2003 JP 2003176034**

(71) Applicant: **Keisoku Giken Co., Ltd.**
**Yokohama, Kanagawa 224-0037 (JP)**

(72) Inventor: **NITADORI, Kenji**
**Keisoku Giken Co., Ltd.**
**Yokohama, Kanagawa 224-0037 (JP)**

(74) Representative:
**Staudt, Hans-Peter, Dipl.-Ing. et al**
**Bittner & Partner,**
**Harderstrasse 39**
**85049 Ingolstadt (DE)**

# (54) Electronic load apparatus

(57) The electronic load apparatus where an inductance is given to the source of a transistor for controlling load current, so that the frequency response characteristic of the electronic load control loop and the electronic load transient response characteristics at the starting of the power supply to be tested are improved; and by providing a non-linear element between the input and output of an operational amplifier for the driving transistor of the controlling circuit, a better load current control characteristic is obtained in a wide load current range. In an apparatus where a plurality of electronic load modules are connected together in parallel, by adding a voltage signal converted from the output of a voltage generating circuit for correcting load current slew rate by the correcting coefficient adding circuit for adding a coefficient which is inversely proportional to the residual inductance to a voltage generated in a reference voltage generating circuit for controlling load current, a voltage saturation in the load transistor when the transistor works at a low voltage can be prevented, so that the load current slew rate of the electronic load apparatus is improved. Further, in an AC electronic load apparatus, an inductance for compensating frequency characteristics is given to the source of the load current control transistor in series. Therefore, the frequency response characteristics of the load current control feedback loop is greatly improved, and even at the cross over point where the current polarity is changed, the apparatus operates without causing a large distortion, and thus the apparatus can be used to test the AC power supply working with a high frequency.

*Fig. 10*

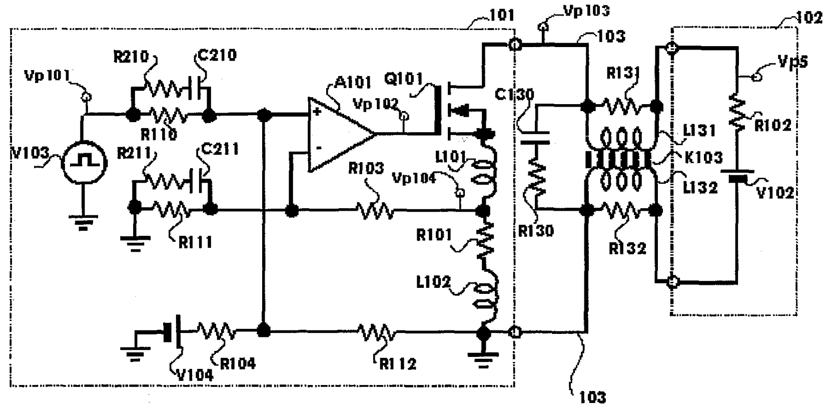


EP 1 467 215 A2

Printed by Jouve, 75001 PARIS (FR)

## Description

Background of the Invention

1) Field of the Invention

The present invention relates to an electronic load apparatus which is used as a load on DC power supply apparatuses, primary batteries, secondary batteries, fuel cell batteries, etc. The invention particularly relates to an electronic load apparatus which is used to test the characteristics of power source apparatuses which are undergoing rapid change of load current tests.

Further, the present invention relates to an electronic load apparatus which is used as a load on AC power supply apparatuses or uninterruptible power supply apparatuses, etc. The invention particularly relates to an electronic load apparatus with a high frequency for testing the characteristics of AC power supply apparatuses, such as inverter-type power supplies or high frequency power supplies.

2) Related Art

Fig. 1 is a circuit diagram showing a conventional electronic load apparatus 11 and a power supply 12 to be tested thereby. The voltage output terminal of the power supply 12 is connected to the electronic load apparatus 11 via cables 13. When setting a voltage Ein corresponding to a given load current IL at the control voltage source V11 for setting the load current, the output of the control voltage V11 and the voltage of the shunt resistance R11 for detecting the load current are compared in the operational amplifier A11. The gate of the load transistor Q11 is driven by the output voltage of the operational amplifier A11, so that the load current IL, which is shown by the Formula (1), flows in a non-saturated region of the load transistor Q11.

$$IL = Ein/R11 \qquad (1)$$

In order to perform a dynamic load effect test on a power supply under test, a control voltage for setting a current corresponding to a bivalent load current is set to obtain the desired load current waveform for the power supply under test. A rectangular wave-shaped output voltage or a sign wave-shaped voltage having an alternatively outputted control voltage, or an arbitrary wave voltage, can be considered. In order to test the characteristics of the power supply which is undergoing a rapid change of load current, the changing load current is required to be at a high slew rate at the electronic load apparatus 11. Therefore, it is necessary to widen the frequency characteristic of the load current control loop, which is comprised of the operational amplifier A11 and the load transistor Q11, as much as possible, to accelerate the control response characteristics.

In order to flow a fast load current, it is required to sufficiently lower the impedance of the cables 13 connecting the power supply 12 and the electronic load apparatus 11. By using cables with a large cross section corresponding to the load current, the impedance could be lowered. However, the inductance component of the cables, which increases in proportion to the length of the cables, has the effect of slowing the control response characteristics.

Fig. 2 is a circuit diagram showing a conventional electronic load apparatus and a power supply under test where the influence of the cable inductance is eliminated. In Fig. 2, the voltage 23 for controlling the load current generates a rectangular wave shape with a predetermined time interval. The difference between the output voltage corresponding to the load current, which is detected by the shunt resistance R21, and the voltage at V23 for controlling load current is amplified in the operational amplifier A21, outputted to the gate of the load transistor Q21 and then supplied to the power supply 22 via the connecting cables 23 to perform a dynamic load effect test.

The power supply 22 is comprised of a voltage V22 and an internal resistance R22. In an arrangement whereby equivalent inductances of the connecting cables 23 are L21 and L22, respectively, which are arranged in parallel lines or twisted lines in order that the magnet fluxes thereof cross each other, the mutual inductance is M, and the inductance component due to the connecting cables between the power supply 22 and the electronic load apparatus 21 becomes L as shown in Formula (2).

$$L = L21 + L22 - 2 \times M \qquad (2)$$

When the slew rate is defined as S, as shown in Formula (3), the voltage drop e caused by the connecting cables 23 when the dynamic load current increases is represented by Formula 4, due to the equivalent inductance L of the connecting cables 23. When the voltage drop e becomes close to the direct output voltage of the power supply 22, the drain-source voltage of the load transistor Q21 is saturated. Then the slew rate S, can be derived from Formula (5), which is shown in Formula (6).

$$S = di/dt \quad (3)$$

$$e = L \times S = L \times di/dt \quad (4)$$

$$L \times di/dt = E \quad (5)$$

$$S = di/dt = E/L \quad (6)$$

When the output voltage of the power supply 22 is E, the saturating time of the drain-source voltage of the load transistor Q21 is T, the saturation time T is presented by Formula (7); there is an inconvenience whereby the load current does not correspond to an inherent current value or inherent current wave shape during the voltage saturation. Conventionally, in order to prevent this, the connecting cables are shortened to decrease the equivalent inductance L caused by the connecting cables, so that a load current wave shape with a high slew rate can be obtained.

$$T = L \times I/E \quad (7)$$

On the other hand its behavior is to be considered when the transient current wave shape is not questioned, and the equivalent inductance is large due to the long connecting cable, for example, during a static load test of the power supply under test. In such a case, when the load current is rapidly increased, the above-stated voltage saturation is generated in a short period, however, the current value will become constant at a given set value, therefore, even if such voltage saturation is caused, there wouldn't be a problem in most cases. However, in the conventional electronic load apparatus, it is very difficult to prevent the overshoot which exceeds the value of the current setting in the recovery process from the voltage saturation, so that it is required to set the load with an easy slew rate where no voltage saturation occurs.

The other problem is that the equivalent inductance L of the connecting cables has a great influence on the control loop characteristics of the electronic load. That is to say, when making the frequency band of the control loop wide for a fast response, as the inductance L of the connecting cables increases, the amplitude allowance and the phase allowance of the loop characteristics decrease, causing an overshoot in the transient characteristics and then sometimes the electronic load causes a continuous oscillation. In the conventional apparatus, a filter means, consisting of a capacitor C30 and a resistance R30 is provided in the operational amplifier A21 to lower the frequency band as shown in Fig. 2, so that no oscillation occurs, even if the inductance of the connecting cables becomes large to some degree. However, according to this arrangement, the responding speed has to be sacrificed to a large extent, which blocks the realization of an electronic load fast transient response.

In addition, the task to be solved in such electronic load apparatuses is a start-up test of the power supply to be tested. To perform a start up test of a power supply, a load current or a load resistance is for the most part preliminarily set in the electronic load apparatus when the power of the power supply to be tested is off. At this time, the load current is set up in the electronic load regardless of the fact that no output voltage is applied to the power supply; therefore, the load transistor Q21 is driven with a maximum gate voltage in order to flow the load current. When the power supply is turned ON under such conditions, a short current, which sometimes largely exceeds the set-up load current, flows transiently. It can cause a big problem in conventional electronic load apparatuses or general power supplies to be tested, depending upon the response speed of the control loop for setting the load of the electronic load and the rising time of the output voltage of the power supply under test. In order to prevent the short current, it is arranged in the conventional apparatus in such a way that the terminal voltage of the electronic load is detected; when the detected voltage is lower than a given threshold, assuming that the power supply is turned OFF, the gate drive of the load transistor is interrupted or decreased, and when the detected voltage becomes higher than the threshold, the load current control loop is operated. However, by adding the protection circuit, the time is delayed from the starting of the power supply to the measuring of the load: and there is the further disadvantage that the load current is always interrupted when the voltage is under the threshold.

Fig. 3 is a circuit diagram showing another example of conventional electronic load apparatus and a power supply to be tested, where the influence of the cable inductance is eliminated. In this apparatus, the operational amplifier A31 for controlling the load current is arranged as a differential input circuit; and a setting reference voltage is applied in such a manner that the output voltage of the rectangular wave-shaped voltage generator V33 and the detected voltage of the shunt resistance R31 for detecting the load current are input with a predetermined voltage ratio, which is given by the voltage matching resistances R 33 to R36. Figs. 4A to 4C are graphs showing the operation wave shapes of the apparatus shown in Fig. 3.

As stated above, the problem of flowing the load current fast, centers at the inductance component and is due to the connecting cables or wiring in the current loop from the power supply 32 to the load current controlling transistor Q31 of the electronic load apparatus 31. In Fig. 3, the equivalent inductance of both lines in the electronic load apparatus is represented by L31, L32, respectively, the mutual inductance of the equivalent inductance L31, L32 is denoted by M31, the equivalent inductance of the connecting cables 33 connecting the power supply 32 and the electronic load apparatus 31 is represented by L33, L34, respectively, and the mutual inductance between the equivalent inductance by L 33 and L34 is M33, and the internal equivalent inductance of the power supply 32 is shown as L35.

The equivalent inductance L of the one current loop as a whole from the power supply 32 to the load current control transistor Q31 can be obtained as in the Formula (8). It should be noted the equivalent inductance L is called the residual inductance hereinafter.

$$L = L31 + L32 - M31 + L33 + L34 - M33 + L35 \text{ [H]} \quad (8)$$

It should be noted that both lines in the current loop are arranged to be parallel or twisted so that the magnet flux there is denied and thus the polarity of the mutual inductance becomes minus.

When a rectangular wave-shaped voltage as shown in Fig. 4A is applied from the reference voltage V33 for setting the load current, the load current as shown in Fig. 4B is supplied to the load current controlling transistor Q31. As shown in Fig. 4B, when the load current increases linearly from I1 to I2 in the time difference t1, the drain-source voltage of the load current controlling transistor Q31 is reduced by the induced electromotive force due to the residual inductance of the load current loop as a whole, which is formed from the power supply 32 via the connecting cables 33. The reduction is shown in Fig. 4C. When the rate of change of the load current is represented by the slew rate S in Formula (9), the voltage is reduced by the voltage amount v1 [V] as mentioned in Formula (10).

$$S = (I2 - I1) / t1 \text{ [A/S]} \quad (9)$$

$$v1 = L(di/dt) = L\{(I2-I1)/t1\} = L \times S \text{ [V]} \quad (10)$$

If the drain-source voltage Vds of the load current controlling transistor Q31 decreases to almost zero [V], the electronic load circuit cannot operate actively as a constant current load. By denying the resistance component in the load current loop, since the limit of the voltage V32 of the power supply 32 and the current slew rate is v1 < V32, the approximate operational limit is as shown in Formula (11).

$$S < V32 / L \text{ [A/S]} \quad (11)$$

When the voltage of the power supply 32 is 1 [V], and the residual inductance L in the load current loop is 100 [nH], the limit of the current slew rate S becomes 10 [A/μS] from the Formula (11). That is to say, it is how the residual inductance in the load current loop can be decreased that is an important factor in increasing the maximum load current slew rate.

In order to obtain a higher load current slew rate, the connecting of a plurality of electronic load circuits in parallel was conducted as shown in Fig. 5. By connecting the N blocks of the electronic load circuits in parallel, even if the residual inductance of each one block is the same, the load current slew rate as a whole can be made N times faster. However, the voltage drop due to the residual inductance of the external connecting cables from the power supply 32 to the electronic load apparatus 31, which are not connected in parallel, cannot be improved. In order to solve the problem of voltage drop, it is generally known to connect the load connecting line of each of the electronic load circuit blocks to the voltage output terminals of the power supply 32 directly, which increases the load current slew rate. Furthermore, it is also generally known to provide a resistance network for detecting the mean load current value of the load current controlling transistor of each electronic load circuit block to compensate for the errors in each load current controlling transistor.

Fig. 7 is a circuit diagram showing the configuration of the conventional AC electronic load apparatus 41. An operational principle of the positive polarity side half-wave of the AC power supply 42 to be tested will be explained. In Fig. 7, the equivalent circuit of the AC power supply 42 is shown as the serial circuit consisting of the sign-wave voltage generator E42 and the internal resistance R40. The load current controlling circuit 41 is arranged to flow a constant load current by means of the reference signal AC voltage E41 having the same phase as that of the AC power supply to be tested.

In Fig. 7, when the reference signal AC voltage is E41, the input resistance of the differential amplifier is R42 (equivalent to the resistance R41), the feedback resistance of the differential amplifier is R43 (equivalent to the resistance R44), the shunt resistance for detecting load current is R45, a negative feed back loop is formed where the gate of the transistor Q41 is driven by an error voltage of the reference signal AC voltage amplified by the operational amplifier X41; then the load current iL is obtained as shown in the Formula (12).

$$iL = (E41 \times R42) / (R43 \times R45) \qquad (12)$$

That is to say, the load current iL is in proportion to the reference signal AC voltage E41 without respect to the load voltage, and the AC electronic load apparatus operates to flow a load current having an orthomorphic wave shape to that of the reference signal AC voltage. In order to obtain an electronic load which works in an AC manner, it is necessary for it to be arranged so that the apparatus operates both in positive and negative polarities. Fig. 8 shows an example of such an apparatus, where two circuits as shown in Fig. 7 are prepared, being connected together in series under the conditions whereby the polarity of the reference signal AC voltage to be applied to each circuit is inverted.

In Fig. 8, when the load voltage has one of the polarities, the transistor driving a load current having the other polarity is conducted by means of a freewheel diode; the transistor then operates as an AC electronic load which operates alternatively at every positive and negative polarity. In order to operate the transistor as an AC electronic load for a high frequency AC power supply to be tested, it is necessary to widen the frequency band of the negative feed back loop of the AC electronic load as much as possible. However, the stability of the control system in the negative feed back loop is largely dominated by a resonate phenomenon due to the inductanc e of the connecting cables and the internal parasitic capacitance of the load transistor. According to the prior technique, the frequency compensation of the control loop is performed by the feed back circuit of the operational amplifier. However, as the frequency characteristic of the feedback loop becomes wider in order to make it possible to perform a fast response, the stability of the system is affected and an overshoot or a ringing of the transient characteristic occurs, resulting in an oscillation. In order to prevent this, the capacitance of the capacitors C41 and C51 in the feed back circuit of the amplifiers X41 and X51 are made large; however, the feedback frequency band must be sacrificed and thus an AC electronic load apparatus which operates fast with a wide frequency band cannot be obtained.

The above-stated prior arts are cited in the following publications.

Japanese Patent Preliminarily Publication Hei 06-113450 (paragraphs 4 to 9, Fig. 1)

Japanese Patent Preliminarily Publication 2001-134326 (paragraphs 11 to 14, Fig. 1)

Japanese Patent Preliminarily Publication Hei 03-99308 (Task to be solved by the invention, Fig. 2)

Japanese Patent Preliminarily Publication Hei 10-187255 (paragraphs 28 to 30, Fig. 1)

Japanese Patent Preliminarily Publication Hei 06-189554 (paragraphs 5 to 11, Fig. 1)

Japanese Patent Preliminarily Publication Hei 07-92215 (paragraphs 6 to 15, Fig. 1)

## Summary of the Invention

The present invention has for its purpose to solve the problems in the conventional apparatus, i.e. the responding characteristics of an electronic apparatus controlling loop when the load current sharply changes, the influence of the connecting cables between electronic load apparatus and power supply to be tested, and the overshoot due to the delay of the recovery time from the voltage saturation are solved; and to provide an electronic load apparatus realizing a sharply varied load current and a wide frequency response characteristic.

The present invention has for its second purpose to solve the problem, which is caused when a plurality of electronic load circuit blocks are connected in parallel. That is to say, by configuration the load current is evenly distributed to the load current controlling transistors of each block, the N times slew rate can be realized only when the residual inductance from each load current controlling transistor to load terminals connected to the power supply are equal. In other words, if the residual inductance of the cables connecting to the power supply is biased, the load current slew rate of the electronic load apparatus is limited. This is caused by the fact that the electronic load block having the largest residual inductance of the load cables causes voltage saturation. In such a case, even the residual inductance of the load line of the other electronic load circuit blocks are low, and the load current slew rate is limited.

The third purpose of the present invention is to provide an AC electronic load apparatus, where even if the equivalent inductance of the connecting cables between the electronic load and the AC power supply to be tested is large, a fast transient response can be performed without making the frequency band of the load current control loop narrow.

In order to realize an AC electronic load, which is applicable to an AC power supply with high frequency or a load current with a high crest factor, it is required to vary the load current with a high slew rate. In order to realize this, the frequency characteristics of the load current control loop consisting of an operational amplifier and a load transistor should be widened as much as possible so as to make the control transient response characteristics of the AC electronic load fast.

However, as mentioned above, the equivalent inductance of the connecting cables to the AC power supply has a great influence on the load control loop of the AC electronic load. Therefore, when the frequency band of the load current control loop is widened for fast transient response, as the inductance L of the connecting cables to the AC power supply increases, the amplitude allowance and the phase allowance in the load current control loop characteristics are reduced, so that an overshoot is generated in the transient response and then a continuous oscillation may occur in the AC electronic load. In the conventional apparatus, a capacitor is inserted in the load current control loop (Fig. 8, C41, C51, C42, C52) to lower the frequency band so that no oscillation occurs even if the inductance L of the connecting cables to the AC power supply is large to some extent. In a conventional configuration, however, the transient response is largely sacrificed and therefore, an AC electronic load having a fast transient response is not able to be performed.

In order to carry out the above stated purpose, the present invention has the first aspect that: an electronic load apparatus comprising a transistor as a load of a power supply under test, which operates in a non-saturated region where a drain-source current flows in proportion to a gate driving voltage, and a controlling circuit for controlling the apparatus such that a current corresponding to a set current is supplied to said transistor, wherein an inductance L is inserted to the source of said load transistor in series.

Further, the present invention is arranged such that a non-linear element is inserted in a feedback circuit of the amplifier, comprised of said controlling circuit.

The present invention has a second aspect that: an electronic load apparatus comprising a plurality of electronic load circuit blocks being connected in parallel to obtain a high load current slew rate, comprising a voltage generating means for correcting load current slew rate, by which a rising slew rate of the waveform of a reference voltage for setting load current in each electronic load circuit block is arbitrarily able to be controlled in accordance with the difference of residual inductance from the load current control transistor of each electronic load circuit block to load terminals being connected to said power supply under test. According to the second aspect, the induced voltage drop due to the residual inductance in the load current loop of each electronic load circuit block can be controlled in the same manner, and thus the maximum load current slew rate can be obtained in the electronic load apparatus, consisting of a plurality of electronic load blocks as a whole.

The present invention has a third aspect that: an AC electronic load apparatus comprising a transistor as a load of an AC power supply under test, operating in a non-saturated region where the drain-source current flows in proportion to the gate driving voltage of the transistor, and the control circuit for controlling the apparatus such that the current corresponding to the given load current amount is supplied to said transistor, wherein the inductance L is provided to the source of said load transistor in series. According to the third aspect, it is possible to provide an AC electronic load apparatus whereby a fast transient response is realized, which is greatly improved in comparison to the conventional AC electronic load apparatus.

<u>Brief Description of the Drawings</u>

Fig. 1 is a circuit diagram showing a conventional electronic load apparatus:

Fig. 2 is a circuit diagram depicting another conventional electronic load apparatus, where the effect of connecting cables is improved;

Fig. 3 is a circuit diagram illustrating another conventional electronic load apparatus, where the effect of connecting cables is improved;

Figs. 4A to 4C are wave shapes of the circuit configuration illustrated in Fig. 3;

Fig. 5 is a circuit diagram representing a conventional electronic load apparatus having a plurality of electronic load modules;

Fig. 6 is a circuit diagram showing another conventional electronic load apparatus having a plurality of electronic load modules;

Fig. 7 is a circuit diagram for explaining the principle of positive polarity half wave of a conventional AC electronic load apparatus;

Fig. 8 is a circuit diagram depicting another conventional AC electronic load apparatus;

Fig. 9 is a circuit diagram illustrating a conventional electronic load apparatus;

Fig. 10 is a circuit diagram representing an electronic load apparatus according to the first aspect of the present invention;

Figs. 11A~11D are graphs showing frequency response characteristics in the apparatus illustrated in Fig. 9;

Figs. 12A~12D are graphs illustrating frequency response characteristics in the apparatus represented in Fig. 10;

Fig. 13 is a circuit diagram for explaining how to detect a gate current in the present invention.

Fig. 14 is a circuit diagram for explaining another way to detect a gate current in the present invention;

Figs. 15A to 15C are graphs showing time-response characteristics in the conventional apparatus illustrated in Fig. 9;

Figs. 16A to 16C are graphs depicting time response characteristics in the apparatus shown in Fig. 10 according to the first aspect of the invention shown in Fig. 10;

Fig. 17 is a circuit diagram illustrating a conventional electronic load apparatus where a starting characteristic is improved;

Fig. 18 is a circuit diagram representing an electronic load apparatus according to the first aspect of the present invention, where a starting characteristic is improved;

Figs. 19A and 19B are graphs showing starting characteristics in the conventional apparatus illustrated in Fig. 17;

Figs. 20A and 20B are graphs depicting starting characteristics in the apparatus of the present invention illustrated in Fig. 18;

Fig. 21 is a circuit diagram illustrating an electronic load apparatus of another embodiment of the present invention;

Fig. 22 is a circuit diagram representing an electronic load apparatus according to still another embodiment of the present invention;

Fig. 23 is a circuit diagram representing an electronic load apparatus according to still another embodiment of the present invention;

Fig. 24 is a circuit diagram representing an electronic load apparatus according to still another embodiment of the present invention;

Figs. 25A to 25D are schematic views showing the configuration of non-linear elements used in the apparatus of the present invention;

Figs. 26A to 26D are schematic views showing the configuration of another non-linear element used in the apparatus of the present invention;

Fig. 27 is a circuit diagram representing an electronic load apparatus according to still another embodiment of the present invention;

Figs. 28A to 28F are graphs showing frequency response characteristics in the apparatus shown in Fig. 27;

Fig. 29 is a circuit diagram depicting an electronic load apparatus according to the second aspect of the present invention;

Figs. 30A to 30D are graphs illustrating operation wave forms in the apparatus depicted in Fig. 29;

Fig. 31 is a circuit diagram representing the configuration of a voltage generator for correction;

Figs. 32A to 32C are graphs showing operation wave forms in the generator shown in Fig. 31;

Fig. 33 is a circuit diagram illustrating the configuration of a conventional AC electronic load apparatus;

Fig. 34 is a circuit diagram representing the configuration of an embodiment of an AC electronic load apparatus according to the third aspect of the present invention;

Figs. 35A to 35D are graphs showing frequency response characteristics in the conventional apparatus illustrated in Fig. 33;

Figs. 36A to 36D are graphs showing frequency response characteristics in the apparatus of the present invention represented in Fig. 34;

Figs. 37A to 37F are graphs depicting response characteristics in the conventional apparatus illustrated in Fig. 33;

Figs. 38A to 38F are graphs depicting response characteristics in the apparatus according to the invention illustrated in Fig. 34;

Figs. 39A to 39F are graphs depicting response characteristics in the apparatus according to the invention illustrated in Fig. 34;

Fig. 40 is a circuit diagram showing the configuration of another embodiment of the AC electronic load apparatus according to the invention;

Figs. 41A to 41F are graphs illustrating response characteristics of current wave forms in the apparatus shown in Fig. 40;

Fig. 42 is a circuit diagram representing the configuration of another embodiment of the AC electronic load apparatus according to the invention; and

Fig. 43A to 43D are graphs showing response characteristics of current wave forms in the apparatus shown in Fig. 42.

Detailed Explanation of the Preferred Embodiments

Preferred embodiments of the present invention will be explained in detail, referring to the attached drawings.

First, the first aspect of the present invention will be explained, referring to Figs. 9 to 28.

Fig. 9 shows a basic configuration of a conventional electronic load apparatus. The output voltage of the load current contr ol voltage V103 is synthesized with the voltage outputted from the offset adjusting voltage V104 via resisters R110 and R104, respectively; then provided to one of the inputs of the operational amplifier A101. On the other hand, the output voltage, which corresponds to the load current, detected by the shunt resistance R101 for detecting the load current, is supplied to the other input of the operational amplifier A101 via the resistance R103, forming a negative feedback control loop. The transistor Q101 is driven by the output voltage of the operational amplifier A101 to perform an electronic load test of the power supply 102, which is connected to the electronic load via connecting cables 103.

The present inventor conducted a simulation for the characteristics of the conventional electronic load apparatus shown in Fig. 9. Such a simulation is generally conducted by inserting a capacitor C110 in the feedback circuit of the operational amplifier A101. For the simulation, an operational amplifier having a broad frequency band is used in the present invention. It is normally not used in such conventional apparatuses as shown in Fig. 9, because it is difficult to obtain a fast transient response.

Fig. 10 shows the configuration of an embodiment of the first aspect of the present invention. As shown in Fig. 10, an inductance L101 is inserted to the source of the field effect transistor Q101 in series. In order to bring out the feature of the present invention, an amplifier that has a sufficiently wider frequency band than the frequency characteristics of the forward transfer admittance of the field effect transistor Q101, and a high slew rate of output voltage is used. The simulation was performed under the conditions that t he connecting cables, the output voltage of the power supply to be tested, the load current, etc. are set to be the same as those in the apparatus shown in Fig. 9.

Figs. 11A to 11D show frequency characteristics of each portion of the conventional apparatus in Fig. 9 and feedback loop characteristics thereof The output voltage V102 of the power supply to be tested is 5[V], the load current is about 5 [A]; the inductance L131, L132 of the connecting cables are 1 [μH] and 10[μH], 100 [μH], respectively; and the coupling factor K3 is 0.9.

According to the frequency characteristics of each portion, when the gate voltage of the field effect transistor Q101 is input the frequency characteristics of the drain voltage increase in proportion to the increase of frequency, due to the inductance L131, L132 of the connecting cables 103 (Fig. 11B). The peaks appear at the parallel resonant frequency of the inductance and the capacitance between the drain and source of the field effect transistor Q101. At the frequency when the voltage amplifying degree increases the gain of the feedback loop is also greatly influenced as shown in Fig. 11D; therefore, the system becomes unstable or a continuous oscillation occurs. In order to prevent this, the capacitance of the feed back capacitor C110 is made so great that the loop gain becomes 0dB or less at a frequency lower than the resonate frequency of the inductance L131 and L132 of the connecting cables. Therefore, the frequency characteristics up to the output voltage of the operational amplifier A101, to which the voltage at the shunt resistance R 101 is input, show a significantly small frequency band.

It should be noted that the capacitor C130 and the resistance R130 in Figs. 9 and 10 are provided in order to damage the resonant phenomenon caused by the inductance of the connecting cables and the parasite capacitance between the drain and source of the field effect transistor Q101, and to increase the stability of the feed back loop; the impedance thereof is within a range that the load current wave forms are not influenced.

The present inventor also conducted the same simulation for the apparatus of the present invention shown in Fig. 10. Figs. 12A to 12D are graphs showing the result of the simulation. According to the frequency characteristics of the voltage amplification degree for each portion, the frequency characteristics up to the output of the operational amplifier A101, to which a voltage at both ends of the shunt resistances (R101 and L102) is input, are very high and extend in a wide band corresponding to the amplification degree when non-feedback is provided in the operational amplifier A101. The voltage amplification degree up to the drain of the transistor Q101, to which the gate voltage is input, depends on the equivalent inductance of the connecting cables 103; however, according to the present invention, the inductance L101 is inserted at the source of the field effect transistor Q101, as a result a current feedback is realized due to the impedance of the inductance L101. Therefore, there is no steep peak in the intermediate frequency band and a flat frequency characteristic is realized as shown in Fig. 12B.

In the present embodiment shown in Fig. 10, the inductance L102 is inserted in series to the shunt resistance R101, so that the inductance L102 performs a frequency compensation of the one loop characteristic with respect to the frequency characteristics of the output voltage of the shunt resistance R101 to the load current. It should be noted when an inductance inherently existing in the shunt resistance is sufficient for the above-mentioned effect, it may be not necessary to provide the inductance L102 externally. The frequency characteristic of the shunt resistance R101 and the inductance L102 can be represented by the following Formula (13).

$$\tau 1 = L102 / R101 \qquad (13)$$

wherein τ 1 is a corner frequency.

Further, when the corner frequency is f1, the following Formula (14) is obtained.

$$F1 = 1/(2\pi \times \tau 1)=R101/(2\pi \times L102) \qquad (14)$$

It can be understood from Formula (14) that the amplitude characteristic of +6db/oct is obtained at a high frequency, setting up the borderline of the frequency f1. The phase is advanced to a maximum of 90 degrees, which effectively functions to perform frequency compensation with respect to the stability of the one loop characteristic.

It is a disadvantage that a wave shape, which is different from the load current, may be detected due to the fact that a differential element is added to the frequency characteristic of the load current detected by the shunt resistance R101 and the inductance L102. That is to say, the frequency characteristic of the feedback circuit of the current control negative feedback loop becomes non-flat. In the present embodiment, in order to prevent this disadvantage, a capacitor C210 is inserted to the input resistance R110, which is the other element of the feedback circuit, in parallel, so as to obtain a time constant τ1. Therefore, the frequency characteristic from the input signal for setting a load current to the load current is kept flat, so that the load current waveform which is equivalent to the current output waveform of the voltage V103 for setting a load current can be obtained.

In Fig. 10, a resistance R210 is inserted into the capacitor C210. This arrangement is to improve the frequency characteristic in a sufficiently high frequency range more than the corner frequency, which is determined by the time constant τ1. The value of the resistance R210 is selected to be a sufficiently smaller value than that of the resistance R110. Further, in order to make it operate as a differential input signal, a resistance R111 and a capacitor C211 having the same constant of the resistance R110 and the capacitor C210 are inserted to the other input terminal of the amplifier A101.

The stability of one feedback loop characteristic will be explained. The frequency characteristic of the drain current with respect to the gate input voltage of the field effect transistor Q101, which is used as a load transistor, is represented by the characteristic of the forward transfer admittance yfs. The admittance gradually decreases after a peak of 1~10 [MHz] when a general FET is used. Taking the parasite capacitance in the field effect transistor into consideration, the source current is folded not only to the drain current determined by the characteristic of the forward transfer admittance yfs, but also to the gate current due to the capacitance between the gate and the source.

In order to correctly detect the load current with the exclusion of the gate current, the circuit shown in Fig. 13 can be used. In this circuit, the shunt resistance R101 can correctly detect the load current without including the gate current. However, the forward transfer admittance becomes 0 with a great phase delay as the frequency becomes high. This has a bad influence on the loop characteristic.

By using the circuit configuration shown in Fig. 14, not only the load current, but the load current including a gate current is detected, so that the phase delay in a high frequency range can be restricted to the minimum and thus the stability of the loop characteristic is improved. In this case, the actual load current is not detected, however, the effect therefrom is very low because the frequency is sufficiently higher than the frequency band necessary for the load current and the gate current is sufficiently low in comparison to the load current. This arrangement is sufficiently effective to obtain stability in systems such as high frequency oscillation systems.

The characteristics in the frequency region of the present invention and the prior arts have been explained above. It is clearly understood that the frequency range of the present invention has been widened to about 100 times that of the prior arts at the frequency where the loop gain is 1; further, both the amplitude allowance and phase allowance are improved with respect to the change of the inductance of the connecting cables.

The characteristics in the time region of the first aspect of the present invention will be explained on the basis of a simulation, being compared with the prior arts.

The responding characteristics of the load current in the conventional circuit in Fig. 9 and the present invention in Fig. 10 are obtained through simulation, at settings such that the output voltage V102 of the power supply 102 is 5 [V], the rising time of the load current set up signal V103 is 1[μs], the load current is 0~5[A], the inductance L131, L132 of the connecting cables 103 is 1[μH], 10[ μH], 100[ μH], respectively, and the connecting constant is K3=0.9

Figs. 15A to 15C are graphs showing the time characteristic of the conventional circuit shown in Fig. 9, while Figs. 16A to 16C are graphs illustrating the time characteristics of the first aspect of the present invention shown in Fig. 10. Figs. 15A and 16A show wave shapes of the load current set up signal V103, respectively; Figs. 15B and 16B represent wave shapes of the drain-source voltage of the filed effect transistor Q101, respectively; and Figs. 15C and 16C illustrate wave shapes of the load current, of the conventional apparatus and the present invention, respectively.

In the conventional apparatus shown in Fig. 9, even when the inductance of the connecting cables is low and the drain-source voltage is not saturated, the rising time is long, because the frequency band of the controlling system is not sufficient; further when the inductance of the connecting cables 103 is high, an overshoot, which largely exceeds the setup current, occurs in the recovery process from saturation.

In contrast to this, the load current wave shapes (Figs. 16A to 16C) of the present invention in Fig. 10 show that the response is sufficiently quick and almost the same wave shapes to those of wave shapes of the set-up load current are realized. Further, even if the inductance of the connecting cables 103 is large and the drain-source voltage is saturated, the overshoot of the load current generated in the recovery process is very small. That is to say, the present invention shows improved response characteristics in comparison to the conventional apparatus shown in Fig. 9.

The response characteristics of the startup test of the power supply to be tested will be explained. Fig. 17 is a circuit diagram showing the configuration of the conventional apparatus, while Fig. 18 is a circuit diagram illustrating the configuration of the present invention. In both circuits, the load current set-up voltage V101 is preliminarily set so that the load current becomes 5[A]; it is conditioned such that the output voltage wave shape rises from non-output voltage to the rated output voltage when the power supply is started up, is replaced by a trapezoidal wave generator V106 so that the output voltage becomes 5[V] at the rising time 1 [μS]; then the load current wave shape is obtained by a simulation where the inductance L131 and L132 of the connecting cable 103 is 1[μH], 10[μH], 100[μH], respectively, and the connecting coefficient K3 =0.9.

Figs. 19A and 19B are output wave shapes of the conventional apparatus shown in Fig. 17; while Fig. 20A and 20B are output wave shapes of the present invention shown in Fig. 18. Figs. 19A and 20A show output voltage wave shapes of the power supply 102 under test, respectively; and Figs. 19B and 20B show load current wave shapes, respectively. In the conventional apparatus shown in Fig. 17, before starting the power supply up, the gate voltage of the field effect transistor Q101 is driven at maximum to flow the load current to the apparatus, and then the power supply is started up. Therefore, an extremely large load current comes at once as is shown in Fig. 19B. Further, concerning the function of the current control loop, the slew rate of the output voltage of the operational amplifier is very slow due to the existence of a capacitor C110 inserted in the feedback circuit of the amplifier for frequency compensation of the controlling system. Therefore it takes a long time to recover the setup current value. This is caused depending upon the system of the frequency compensation circuit, and therefore it cannot be solved by broadening the frequency range of the operational amplifier. This is fatal for electronic load apparatuses when performing a startup test of the power supply. Therefore, the above-mentioned load current interrupting circuit should be provided as an expediential means.

While, according to the first aspect of the present invention shown in Fig. 18, and as is apparent from the load current wave shapes shown in Fig. 20B, an electronic load with very few overshoots in the load current can be realized without depending on the inductance of the connecting cable 103.

Fig. 21 is a circuit diagram showing the configuration of another embodiment of the present invention. In this embodiment, an inductance L101 is connected to the source of the load transistor Q101 so as to connect the shunt resistance R101 for detecting the load current to the transistor via the inductance L101. Fig. 22 is a circuit diagram illustrating the configuration of still another embodiment of the present invention, where the shunt resistance R101 is connected to the source of the load transistor Q101, and the inductance L101 is connected to the source of the load transistor via the shunt resistance R101. In these embodiments, the feedback control of the load current is performed by detecting a differential input at both ends of the shunt resistor R101, so that the connecting order of the inductance L101 and the shunt resistance R101 to the source of the load transistor Q101 does not influence the effect of the invention.

Figs. 23 to 28 are circuit diagrams for explaining still another embodiment according to the first aspect of the present invention. Figs. 23 and 24 are for explaining the principle of the embodiment. In this embodiment, a non-linear element such as a diode(s) is inserted between the output of the operational amplifier and input terminals thereof, from which a fast response characteristic is available in a large range from a very small load current to a large load current and stable operation can be realized. The embodiment will be explained in more detail, referring to the drawings and a simulation result. It should be noted that the amplifying portion of the load current controlling circuit is represented by one operational amplifier, however it may be possible to combine a plurality of operational amplifiers having a preferred characteristic. By inserting a non-linear element, i.e. diode (s), in the negative feedback circuit of the last stage of the operational amplifiers, which drives the field effect transistor for controlling a load, the amplification degree can be varied so as to correspond to the gate voltage of the field effect transistor.

Figs. 25A to 25D, and Figs. 26A to 26D show examples of non-linear element configurations. In Figs. 25A to 25D, diodes are installed as a non-linear element having two terminals, where one to n diodes D(1) to D(n), or a resistance RD1 and one to n diodes D(1) to D(n) are provided. As shown in Figs. 25C and 25D, a Zener diode ZD(1) may be used.

Figs. 26A to 26D show examples where a non-linear element having three terminals is used. Fig. 26A shows an example where the non-linear element comprises a diode D(1), a Zener diode ZD(1) and a resistance RD13; Fig.

26B shows an example where further resistances RD11 and RD 12 are added; Fig. 26C illustrates an example where one to n diodes DJ1(1) to DJ1(n) are provided at the junction BJ1 side and one to m diodes DJ2(a) to DJ2(m) are provided at the junction BJ2; and Fig. 26D shows a configuration where the resistances RD11 and RD12 are added to the configuration shown in Fig. 26C. The function and effect are the same in all of the embodiments. It should be noted that capacitors for frequency compensation may be added to the diodes and a combination of a resistance and a bias voltage, etc. may be used to optimize the non-linear characteristics.

An N-channel transistor is used in this embodiment. In the case of using P-channel transistor(s), the same effect can be obtained by changing the polarity of the connection of the non-linear elements.

Fig. 27 shows a circuit diagram concretizing the circuit shown in Fig. 23. Figs. 28A to 28F show the simulation result of frequency characteristics of each part of the circuit and the circuit as a whole. In these graphs, the simulation results are superimposed, adjusting bias voltage so as to make the load current from about 10[mA] to 10[A].

Concerning the characteristic of the field effect transistor Q101 for the load control, the forward transfer admittance yfs is varied depending on the size of the drain current, i.e. the size of the load current. Particularly, when the drain current is set at low, the gate voltage nears the pinch-off voltage, and the forward transfer admittance yfs becomes extremely small.

Fig. 28C shows a characteristic of drain current with respect to the gate voltage of the field effect transistor Q101, where the amplification degree is varied about 50[dB] in the lower frequency region with respect to the variation of load current, and the frequency band is also varied. In the conventional apparatus, the feedback loop for the load current control is constructed keeping the above-said characteristics. Therefore, even if the frequency compensation is performed to make the system stable as a whole range of the load current, the feedback amount lacks to a large extent when the load current is low and the load current flows with a large error with respect to the set-up current value and both the frequency band and the response characteristics are reduced. In contrast thereto, the variation of the negative feedback amount due to the field effect transistor Q101 can be compensated for by the element of diodes having a non-linear characteristic.

Fig. 28B shows a frequency characteristic of the non-linear amplification step when the load current varies from 10[mA] to 10[A], when the non-linear element is inserted into the amplifier of the fmal stage. In a low frequency region, an amplification degree is variable to about 40[dB], therefore, the variation of amplification degree due to the field effect transistor can be compensated. Further, by providing a capacitor C11 to the feedback circuit of the non-linear amplification stage, the variation in the frequency region of the field effect transistor stage can be compensated for to some degree. As is apparent from the amplitude characteristic in Fig. 28E and the phase characteristic in Fig. 28F, the total loop characteristics of the load current control circuit are also improved. That is to say, a sufficient negative feedback amount and a sufficient frequency region are secured in a whole range of load current, and thus a fast responding characteristic is maintained, while keeping the amplitude allowance and phase allowance of the feedback loop.

Figs. 29 to 32 show an electronic load apparatus according to the second aspect of the present invention. In order to make the explanation easy, only three constant current electronic load modules 241 to 243 are connected together in parallel in this embodiment. Figs. 30A to 30D are graphs showing voltage wave shapes of the reference voltage generator 210 for setting load current and the voltage generator 211 for correcting the load current slew rate of the apparatus shown in Fig. 29. The coefficient multipliers 221 to 223 are a means for obtaining a multiplied output voltage multiplied with an arbitrary coefficient with respect to the input of the voltage generator 211; The adders 231 to 233 are a means for adding the output voltage of the voltage generator 210 for setting load current to the output voltage of voltage generator 211 for correcting load current slew rate, which is multiplied by the arbitrary coefficient with the multipliers 221 to 223. A conventionally known means can therefore be used.

As an example where the load current is quickly varied in the apparatus shown in Fig. 29, the situation will be explained whereby a rectangular wave shaped voltage as shown in Fig. 30A is generated by the reference voltage generator 210 for setting load current to obtain a load current being conformable to the thus generated rectangular wave shaped voltage. A voltage wave shape generator is provided where a voltage is generated in such a manner that the load current rises almost linearly being simultaneous to the rising time of the rectangular wave shaped voltage and reattributed to the initial voltage when the rising is ended with an arbitrary time, an arbitrary gradient, or an arbitrary curve as shown in Fig. 30B. This is called a voltage generator 211 for correcting slew rate; the effect of the second aspect of the present invention will be explained below.

When the output voltage of the reference voltage generator 210 for setting load current is VA, the output voltage of the voltage generator 211 for correcting slew rate is VB, the ratio of the output current with respect to the input voltage of the electronic load modules 241 to 243 is defined as a mutual inductance Gm [A/V], and the coefficients of the multipliers 221 to 223 are K1 to K3, respectively, the outputs currents IL1, IL2, IL3 with respect to the input voltages V1, V2, V3 of the electronic load modules 241, 424, 243 are:

$$IL1 = V1 \times Gm = (VA+VB\times K1) \times Gm\ [A] \quad (15)$$

$$IL2 = V2 \times Gm = (VA+VB\ (12)\ K2) \times Gm\ [A] \quad (16)$$

$$IL3 = V3 \times Gm = (VA+VB \times K3) \times Gm\ [A] \quad (17)$$

The coefficients K1 to K3 of the modulators 221 to 223 are selected such that the dimension of the coefficients K1 to K3 become inversed to the order of the dimension of the residual inductances L241, L242, L243 of the electronic load modules 241, 242 and 243, respectively, and the sum of the coefficients become approximately zero. The total output current ILO of the electronic load modules is:

$$ILO = IL1 + IL2 + IL3 = 3 \times VA \times Gm\ [A] \quad (18)$$

As is apparent from Formula (18), the total output current ILO is not affected by the output voltage VB of the voltage generator for correcting slew rate.

As a concrete example, it is assumed that the relationship of the size between the residual inductance of each electronic load module is L241 < L242 < L243; the coefficient K1 in the multiplier 221 of the electronic load module 241 having the smallest residual inductance is set at 0.5 (the wave shape output voltage of the adder 231 according to this coefficient is shown in Fig. 30C); the coefficient K3 in the multiplier 223 for the electronic load module 241 having the largest residual inductance is set at -0.5 (the wave form output voltage of the adder 233 according to the coefficient is shown in Fig. 30D); and the coefficient K2 in the multiplier 222 of the electronic load module 242 having the intermediate residual inductance is set at 0. In this example, the load current slew rate of the reference voltage for setting load current when the current is rising is: when the slew rate of the electronic load module 242 is 100%, the electronic load module 241 becomes 150% and the slew rate of the electronic load module 243 becomes 50%.

In this manner, by changing the load current slew rate of each electronic load module during the increase process of the load current in each electronic load module, when the voltage drop due to the residual inductance of each electronic load module becomes equal, the allowance of inductance becomes 67% for the electronic load module 241 (1/1.5 times) with respect to the electronic load module 242, while that of the electronic load module 243 becomes 200% (1/0.5 times) . As explained above, even if the residual inductance is not implemented, the optimum drive can be obtained. In addition, by determining the coefficient to be set in the multipliers in accordance with the ratio of the residual inductance of each electronic load module in such a manner that the coefficient is inversely proportional to the size of the residual inductance and the total sum of each coefficient becomes about 0, it becomes possible to drive the apparatus with the optimum load current slew rate corresponding to the residual inductance of each electronic load module. In the conventional apparatus, the load current is distributed to each electronic load module of the apparatus in an even manner. While, according to the invention, the electronic load module located at the shortest distance from the load connecting terminal of the power supply under test and having a minimum residual inductance is burdened with a comparatively large load current slew rate, while the electronic load module located at the furthest distance from the load connecting terminal and having the largest residual inductance has a low load current slew rate. Therefore, the load test with the fastest load current slew rate can be performed, which is measured up to the mean residual inductance of the electronic load apparatus consisting of a plurality of electronic load modules.

In order to realize an electronic load apparatus having a faster load current slew rate, more than three electronic load modules, for instance, 10 to 100 modules may be connected together in parallel. In such a case, the coefficients to be set in the multipliers for compensating slew rate in accordance with the residual inductance of each electronic load module are appropriately selected to be inversely proportional to the size of the residual inductance of each electronic load module, and the sum of the selected coefficient becomes zero or almost zero. According to this configuration, the load current slew rate can be several times faster than the parallel connected modules.

Next, the voltage wave shapes in the voltage generator 210 for correcting load current slew rate will be stated. The wave shape shown in Fig. 30B shows an effect of the invention regarding the voltage wave shape which rises and falls linearly; however, the same effect can be obtained by an almost linear voltage wave shape in the rising process, which is similar to an exponential function curve. In this case, the load current slew rate is slightly different, however, the improvement effect of the load current slew rate for the electronic load modules connected in parallel is not lost to any great degree. Further, there is no strict limitation for the linearity of the voltage wave shape when the voltage is falling. The voltage slew rate when the voltage is dropping is lower than when the voltage is rising, therefore it is preferable to have a longer time for falling than that for rising. Further, the wave shape with an exponential function curve during voltage drop does not influence the total output current of the electronic load modules.

In addition to the situation in Fig. 30B, where the effect of the invention is stated assuming that the amplitude of the voltage wave shape is constant, another method will be explained referring to Fig. 31 and Figs. 32A to 32C, where the amplitude of the voltage for correcting the load current slew rate varies in proportion to the load current slew rate, and thus when the load current slew rate is low, the voltage for correcting load current slew rate barely functions. In the circuit diagram shown in Fig. 31, a signal voltage of the rectangular wave shaped voltage generator 210, which determines the load current wave shape shown in Fig. 32, is input into the input terminal TP-A. A differentiator is comprised of an operational amplifier A281, a capacitor C281, and a resistor R281; a diode D282 is provided so that it can function as a half wave rectifier circuit which outputs a voltage having one polarity only. The output voltage wave shape is as shown in Fig. 32B, which is proportional to the rising voltage slew rate of the voltage wave shape applied to the input terminal TP-A. Further, the next stage is comprised of an operational amplifier A282, a resistor R282 and a capacitor C282 functions.

It should be noted that a discharge resistance R283 is inserted in order to gradually reset the output of the integrator, when the output of the differentiator becomes zero the rising operation of the rectangular wave shape voltage is finished. As a result, the wave shape of the output voltage for correcting load current slew rate at the output terminal TP-C becomes not a linear rising shape but an exponential functional wave shape as shown in Fig. 32C. However, the same effect of the second aspect of the invention can be obtained.

In the wave shapes shown in Figs. 32A to 32C, the solid line illustrates that the load current slew rate is high, while the broken line illustrates that the load current slew rate is low. As is apparent from Figs. 32A to 32C, in proportion to the voltage rising slew rate of the wave shape of the reference voltage for setting load current, when the load current slew rate is high, the effect appears, while, when the load current though rate is low, no effect is obtained. However, for the purpose of the invention, i.e. compensating for the influence of the unevenness of the residual inductance, the effect is required only when the load current slew rate is high. Therefore, even if it does not function when the load current slew rate is low, the purpose of the invention, i.e. the improvement of the load current slew rate in the electronic load apparatus where a plurality of electronic load modules are connected in parallel, is not lost.

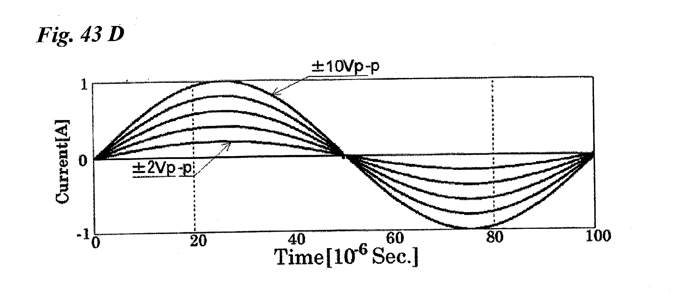

The third aspect of the present invention will be explained, referring to Figs. 33 and 43. The third aspect is concerning an AC electronic load apparatus. Fig. 33 is a circuit diagram which illustrates a conventional AC electronic load apparatus, and Fig. 34 is a circuit diagram illustrating an embodiment of the third aspect of the present invention. The simulation results are shown in Figs. 35A to 35D and Figs. 36A to 36D, respectively. Comparing the circuit configurations in Fig. 33 (conventional apparatus) and in Fig. 34 (present invention), the same parts are used there except for the frequency compensating circuit, and the other conditions, such as the equivalent inductance of the cables for connecting the AC power supply to be tested, and the equivalent model of the AC power supply to be tested, are the same.

In order to prevent a complex explanation , the case of having only one transistor with positive and negative polarity will be explained. However, a desired AC electronic load apparatus satisfying the desired load current or desired load power can be realized by connecting a plurality of circuit blocks including a load current control loop in parallel.

In Figs. 33 and 34, the feed back loop comprised of an operational amplifier X301 and load transistor Q301 actively operates during the time when the AC power supply to be tested outputs a positive voltage, while the feed back loop comprised of an operational amplifier X311 and a load transistor 311 actively operates when the AC power supply to be tested outputs a negative voltage. The reference voltage signal supplied to the amplifiers X301 and X311, which operate alternatively during the positive voltage time period and the negative voltage time period, from the reference voltage power supply E301 via input resistances R301, R302 and input resistances R311, R312; the feedback resistances R303, R304 and R313, R314 from the shunt resistance work as differential signals, respectively.

The inductances L301, L311 inserted into the shunt resistances R305, R315 for detecting a current in series represent a small residual inductance of the shunt resistance. These inductances may be externally provided for a phase compensation of the feedback loop. In the simulation of this embodiment, the shunt resistances R305, R315 are at 0.2 [Ω], and the residual inductances L301, L311 are at 0.1 [μH]. When the time constant is $\tau 1$, the transfer function of the feed back loop due to the residual inductance is represented by the Formula (19).

$$\tau 1 = L301 / R305 \qquad (19)$$

This functions as a first order lead element and the load current is not correctly detected as a load current detecting circuit. However, this problem can be solved by inserting capacitors C303, C304 and C312, C313 each having the time constant of $\tau 1$ to the input resistors R301, R302, and R311, R312, respectively.

The equivalent inductances of the two single cables which occur in accordance with the length of the load connecting cable connected to the AC power supply under test are defined as L321 & L322, and the pair of single cables are arranged as parallel lines or twisted lines in order to cross their magnetic fluxes, then the mutual inductance thereof is defined as M. Then, the equivalent inductance L which occurs between the AC power supply under test and the AC electronic load is viewed as L in the formula (20).

$$L = L321 + L322 - 2 \times M \tag{20}$$

The resistances R321, R322 which are inserted in parallel into the equivalent inductances L321, L322 of said cable are the loss resistance, and are provided for the purpose of bringing the inductance Q on the load connecting cable connected to the AC power supply under test closer to the actual value in the high-frequency zone. A simulation of the characteristics of the conventional AC electronic load apparatus shown in Fig. 33 and of the AC electronic load apparatus according to the present invention is conducted under the condition that the inductance of a single load connecting cable is 1[μH], 10[μH], 100[μH], 1 [mH]; the reciprocating line coefficient of the load connecting cables is K = 0.9, the load voltage of the AC power supply is 100[V], and the load current is 1[A]. It should be noted that the capacitors C301 and C311 in Fig. 33 are for compensating the main frequency of the feed back loop; and capacitors C302 and C312 having the same coefficient are inserted as a differential impedance element. In the circuit shown in Fig. 34, the inductances L303 and L313 which are inserted into the sources of the load transistors Q301 and Q311 in series, respectively, function to compensate the main frequency of the feedback loop; while the capacitors C301 and C311 for compensating the main frequency in the conventional circuit in Fig. 33 can either, not be inserted or they can be used as a very small capacitance.

Figs. 35A to 35D show frequency characteristics of each portion of the load current control loop and one feedback loop characteristic of the conventional AC electronic load apparatus in fig. 33; and Figs. 36A to 36D illustrate characteristics of the apparatus of the present invention shown in Fig. 34. In Figs. 35A to 35D and 36A to 36D, the variations of the characteristics are superimposed when the inductance of a single connecting cable for the AC power supply 302 is 1 [μH], 10[μH], 100[μH], 1[mH]; Figs. 35C and 36C show amplitude characteristics of the loop; and Figs. 35D and 36D are phase characteristics (phase characteristic and longitudinal axis: phase angle 0 and phase difference is a phase allowance) of the circuit configurations in Fig. 33 and Fig. 34, respectively.

In the conventional apparatus shown in Fig. 33, a simulation is performed in such a manner that the frequency compensation for securing the loop amplitude allowance and the phase allowance with respect to the variation of the inductance of the connecting cables to the AC power supply 302 is conducted by the capacitors C301 and C311 and the capacitors C302 and C312; as a result the frequency to obtain a loop gain 1 is about 200[KHz]. On the other hand, in the circuit of the present invention illustrated in Fig. 34, the frequency compensation is conducted by the inductances L303 and L313 which are inserted to the source of the load transistor. Figs. 36C and 36D show the characteristics when the inductances are 5 [μH], respectively, resulting in a wider frequency range which is 10 or more times greater than the conventional circuit configuration.

In Figs. 35A and 36A, the frequency characteristics of the feedback loops of the conventional circuit and the present invention are compared. In the circuit configuration shown in Fig. 35A, the frequency compensation of the loop is performed by the feedback capacitors C301 and C311 of the operational amplifiers, therefore the frequency at which the gain becomes 1 is about 400 [kHz], which is comparatively low. On the other hand, the frequency characteristics of the output voltage of the operational amplifier X301, to which a voltage at both terminals of the shunt resistance R305 and the residual inductance L301 of said shunt resistance is supplied, is about 50~60[MHz] which is extremely high. This feature also greatly affects the wave shape distortion in the time region, which will be explained below.

Figs. 35B and 36B are graphs for comparing the gain frequency characteristics of the output voltage including the shunt resistance R305 and the residual inductance L301 of the shunt resistance and the gate voltage of the load transistor Q301 between the conventional apparatus and the present invention. In the present invention, the loop frequency compensation is conducted by the inductances L303 and L313 which are inserted into the source of the load transistors Q301 and Q311, so that the frequency characteristic is flat with respect to the variation of the inductance due to the connecting cables of the AC power supply 302. It can be said that the present invention provides an AC electronic load apparatus where the total loop characteristic is stable without being influenced by the inductance of the connecting cables and a wide range control system can be obtained.

The characteristics in the time region will be explained using Figs. 37A to 37F and Figs. 38A to 38F, comparing the characteristics that in the conventional circuit configuration shown in Fig. 33 and the present invention illustrated in Fig. 34. In both configurations, a reference voltage signal having a sign wave is applied from the reference AC voltage source E301 for setting the load current; constants in each portion are set so that the load current becomes ± 1.0 [Ap] when the voltage is ± 10[Vp]. Simulation wave shapes of each portion when the reference AC voltage from the reference AC voltage source E301 are varied from ±2[Vp] to ± 10[Vp] with a step of 2[V] are shown in Figs. 37A to 37F and Figs. 38A to 38F. It should be noted that the voltage of the AC power supply to be tested is constant at ± 100[vp].

Figs. 37A to 37F are wave shapes showing characteristics of the conventional apparatus in Fig. 33, where the capacitors C301, C311 and C302, C312 are set at 1[nF]; Figs. 38A to 38F are wave shapes illustrating characteristics of the present invention in Fig. 34, where the inductance L303 and L311 are set at 5[μH]. Figs. 37A and 38A are wave shapes of the reference voltage signals; Figs. 37B and 38B are wave shapes of the gate-source voltage of the load transistor Q301; Figs. 37C and 38C are wave shapes of the drain voltage of the load transistor Q301; Figs. 37D and 38D are wave shapes of the gate-source voltage of the load transistor Q311; Figs. 37E and 38E are wave shapes of the drain voltage of the load transistor Q311; and Figs. 37F and 38F show load current wave shapes.

When the comparison is performed with a reference signal frequency of 10 [KHz], the minimum negative feedback of about 26dB is provided in the conventional configuration as shown in Fig. 35C, however, there is a remarkable distortion at the cross over point at which the polarity of load current is changed as shown in Fig. 37F. This is caused by the fact that the slew rates of the gate-source voltage of the load transistors Q301 and Q311 are largely limited by the feed back capacitors C301 and C311 of the operational amplifiers X301 and X311 for driving the load transistors in spite of the fact that the error signal is large. That is to say, a dead zone of a given time is generated in the small current region where the polarity of the load current is changed, resulting a large cross over distortion.

On the other hand, in the AC electronic load apparatus shown in Fig. 34 according to the invention, a sufficient negative feedback of about 69 [dB] is provided at the reference signal frequency of 10 [KHz] as shown in Fig. 36C, and the frequency band from the error amplification stage to the gate voltage of the load transistor is extremely high. Further, as shown in Figs. 38B and 38D, a control is performed whereby the gate-source voltage of the load transistors Q301 and Q311 correctly reflect the error signal while keeping a high slew rate, which is conducted when no feedback is provided to the operating amplifiers X301 and X311. As a result, excellent respond wave shapes of the load current having almost no cross over distortion can be realized, as shown in Fig. 38.

In Figs. 39A to 39F, the response wave shapes with a reference signal frequency of 100 [KHz] in the circuit configuration of the present invention shown in Fig. 34 are mentioned. In spite of the fact that the reference frequency is ten (10) times higher, it shows a response characteristic more excellent than the characteristic of the conventional circuit configuration in Fig. 37 where the reference frequency is 10 [KHz]. It is understood that a very fast AC electronic load can be realized by the present invention.

The difference in the effect of the load current wave shape distortion in accordance with a pinch off voltage of the load transistor between the conventional circuit and the present invention will be explained. At the cross over point where the control is changed between the positive side load transistor Q301 and the negative side load transistor Q311, a bias voltage corresponding to the pinch off voltage between the gate and source of both the transistors should be given in order to optimize the load current distortion. The pinch off voltage varies depending on the inherent feature of the transistor to be used, or on temperature. Therefore, the gate driving voltage should follow this variation. In the conventional apparatus, however, as stated above, the slew rate becomes very low, and thus a saturation condition is generated where proportional control is not conducted for a given time which is inversely proportional to the low slew rate. As a result, the cross over distortion becomes larger and then the load current wave shape is apt to be influenced by the variation of the load transistor due to the temperature.

In contrast thereto, according to the present invention, the slew rate of the driving voltage of the load transistor can be greater so that the saturation time of the feed back control becomes extremely short. Then, the influence by load current distortion due to the variation of the pinch off voltage of the load transistor can be reduced.

In the above-stated embodiment of the present invention, the load control circuit at a positive polarity side and the load control circuit at a negative polarity side are connected in series, however, it may be possible to arrange them in such a way that the shunt resistance R305 for detecting load current and its residual inductance L301, and the inductance L303 for frequency compensation are commonly used for the load control circuits at the positive and negative polarity sides. Since the load current is detected by the shunt resistance R305 as a differential signal of the operational amplifier, the operation is the same as that of the embodiment shown in Fig. 34. Figs. 41A to 41F show response wave shapes of the reference signal in the circuit configuration shown in Fig. 40 when the reference signal fre quency is 10 [KHz]. The other conditions are the same to those in Fig. 38 and the response characteristics are almost the same as those in the circuit shown in Fig. 34.

Fig. 42 shows a further embodiment of an AC electronic load apparatus according to the third aspect of the present invention. Figs. 43A to 43D are graphs showing wave shapes of the response characteristics of the circuit configuration shown in Fig. 42 when the reference signal frequency is 10 [KHz]. In Fig. 42, an N-channel transistor Q3 01 and P-channel transistor Q302 are used for the load transistors, and diodes D301 and D302 for preventing reverse voltage are connected to the drains of the transistors, respectively. The operation thereof is the same as the above, except for the fact that the shunt resistance for detecting load current and the operational amplifier are commonly used for the positive and negative polarities of the load current. Since the diodes for preventing the reverse voltage are provided in the load transistor, a forward voltage loss, which is caused by the internal resistance of the diodes, is added, and thus a little cross over distortion is caused in the current wave shapes when the load voltage is low. However, the response characteristics are better than those in the conventional AC electronic load apparatus, so that the response characteristics of the AC electronic load are able to be improved while reducing the cost for the parts.

As explained above, the electronic load apparatus according to the first aspect of the present invention shows excellent load current responding characteristics in a wide frequency range in comparison to the conventional electronic load apparatus, and it is apt not to be influenced by the parasite impedance of the connecting cables between the load and power supply to be tested. Therefore, a fast load response characteristic test can be performed for testing a fast load variation or for conducting a characteristic evaluation test when starting the power supply up, which is difficult to be realized in the conventional electronic load apparatus.

Further, according to the second aspect of the present invention, in the electronic load apparatus having a high load current slew rate where a plurality of electronic load modules are connected together in parallel, wave shapes of a load transistor drive voltage can be obtained in which the influence under the transient voltage drop due to the residual inductance of the difference of length of the cables from the electronic load modules to the load terminals can be optimized. The load current slew rate which is limited by the maximum value of the residual inductance of the electronic load modules in the conventional apparatus can be raised to the load current slew rate at the mean value of the residual inductance of the electronic load modules. As a result, the load current slew rate can be multiplied as many times as the number of electronic load modules connected together in parallel.

Furthermore, in the AC electronic load apparatus according to the third aspect of the present invention, an inductance for frequency compensation is connected to the source of the load transistor in series, therefore, the frequency response characteristics of the load control loop can be remarkably improved and an AC electronic load apparatus where no cross over distortion is caused when the positive and negative polarities are changed can be obtained.

## Claims

1. An electronic load apparatus comprising a transistor being operated as a load of a power supply under test, and a control circuit for controlling the apparatus such that a current corresponding to a given load current is supplied to said transistor, and a first inductance being inserted to a source of said transistor in series.

2. An electronic load apparatus according to Claim 1, wherein said transistor operates in a non-saturated region where a drain-source current flows there in proportion to a gate drive voltage thereof.

3. An electronic load apparatus according to Claim 1, wherein said control circuit comprises an operational amplifier for driving a gate of said transistor, and wherein a non-linear element is provided in a feedback circuit of said operational amplifier.

4. An electronic load apparatus according to Claim 1, wherein a second inductance is connected to a shunt resistance for detecting a load current so as to compensate for an output frequency characteristic of said shunt resistance.

5. An electronic load apparatus according to Claim 1, wherein a capacitor is provided so as to be parallel with an input resistance of said operational amplifier.

6. An electronic load apparatus according to Claim 5, where a resistance is inserted to said capacitor in series.

7. An electronic load apparatus according to Claim 1, wherein said first inductance is connected to a shunt resistance for detecting a load current in series.

8. An electronic load apparatus according to Claim 7, wherein a difference at both terminals of said shunt resistance is detected and supplied to said operational amplifier.

9. An electronic load apparatus according to Claim 3, wherein said amplifier having said non-linear element comprises a negative feedback circuit, and wherein a capacitor is inserted to said negative feedback circuit.

10. An electronic load apparatus wherein a plurality of electronic load modules are connected together in parallel comprising a load current slew rate correcting means for controlling a rising slew rate of a wave shape of a reference voltage for setting load current in each electronic load module in accordance with a difference of residual inductance from a load current control transistor in each electronic load module to load terminals that connect the modules to a power supply under test.

11. An electronic load apparatus according to Claim 10, wherein said load current slew rate correcting means comprises a means for providing a coefficient to each electronic load module, wherein said coefficient is selected in such a manner that the order of the size of said coefficients become the reverse of the size of said residual inductance in each electronic load module, and that the total sum of said coefficients becomes zero or almost zero.

**12.** An AC electronic load apparatus comprising a transistor being operated as a load of a power supply to be tested, a controlling circuit for controlling the apparatus such that a current corresponding to a given load current provided to said transistor, and an inductance being inserted to a source of said transistor.

**13.** An AC electronic load apparatus according to Claim 12, wherein said transistor operates in a non-saturated region where a drain-source current flows in proportion to a gate driving voltage of said transistor.

**14.** An AC electronic load apparatus according to Claim 12, wherein said controlling circuit comprises a positive side controlling circuit and a negative side controlling circuit, and wherein a shunt resistance for detecting load current and an inductance being connected to said source of the transistor are commonly used in said positive side and negative side controlling circuits.

*Fig. 1*

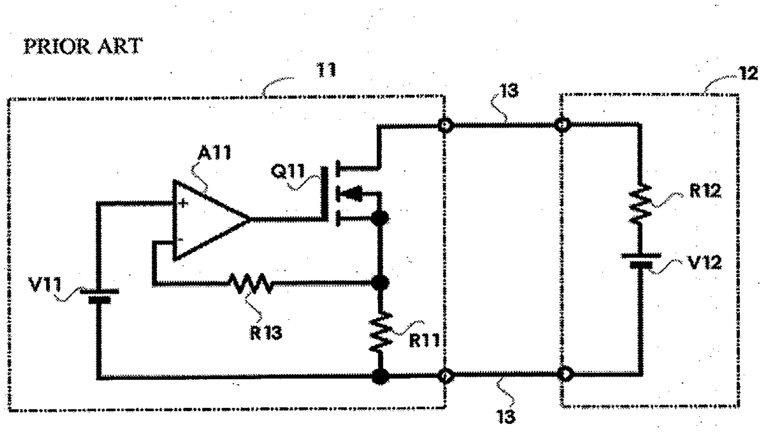


*Fig. 2*

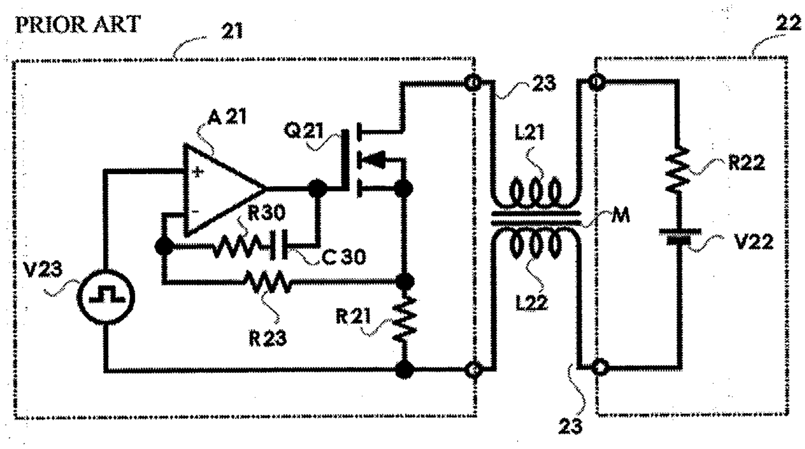


*Fig. 3*

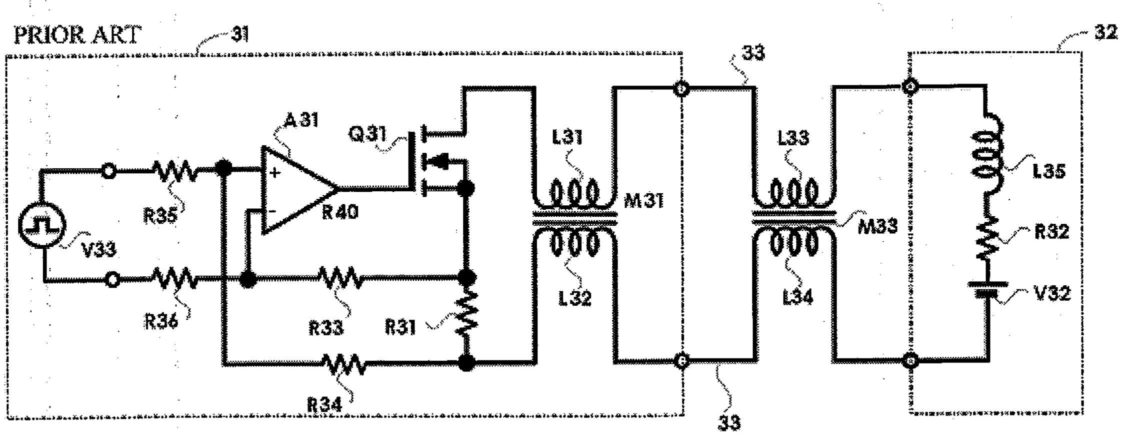

*Fig. 4A*

PRIOR ART

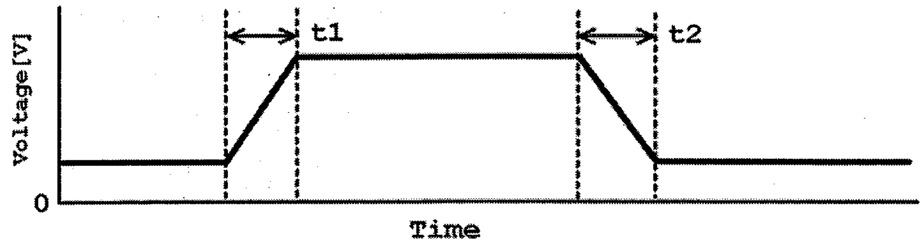


*Fig. 4B*

PRIOR ART

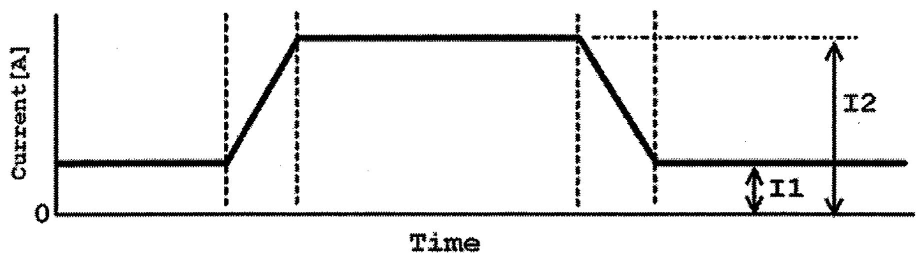


*Fig. 4C*

PRIOR ART

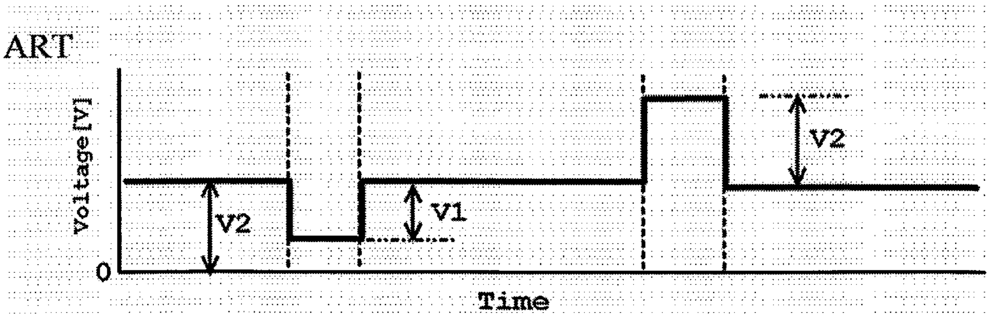

*Fig. 5*

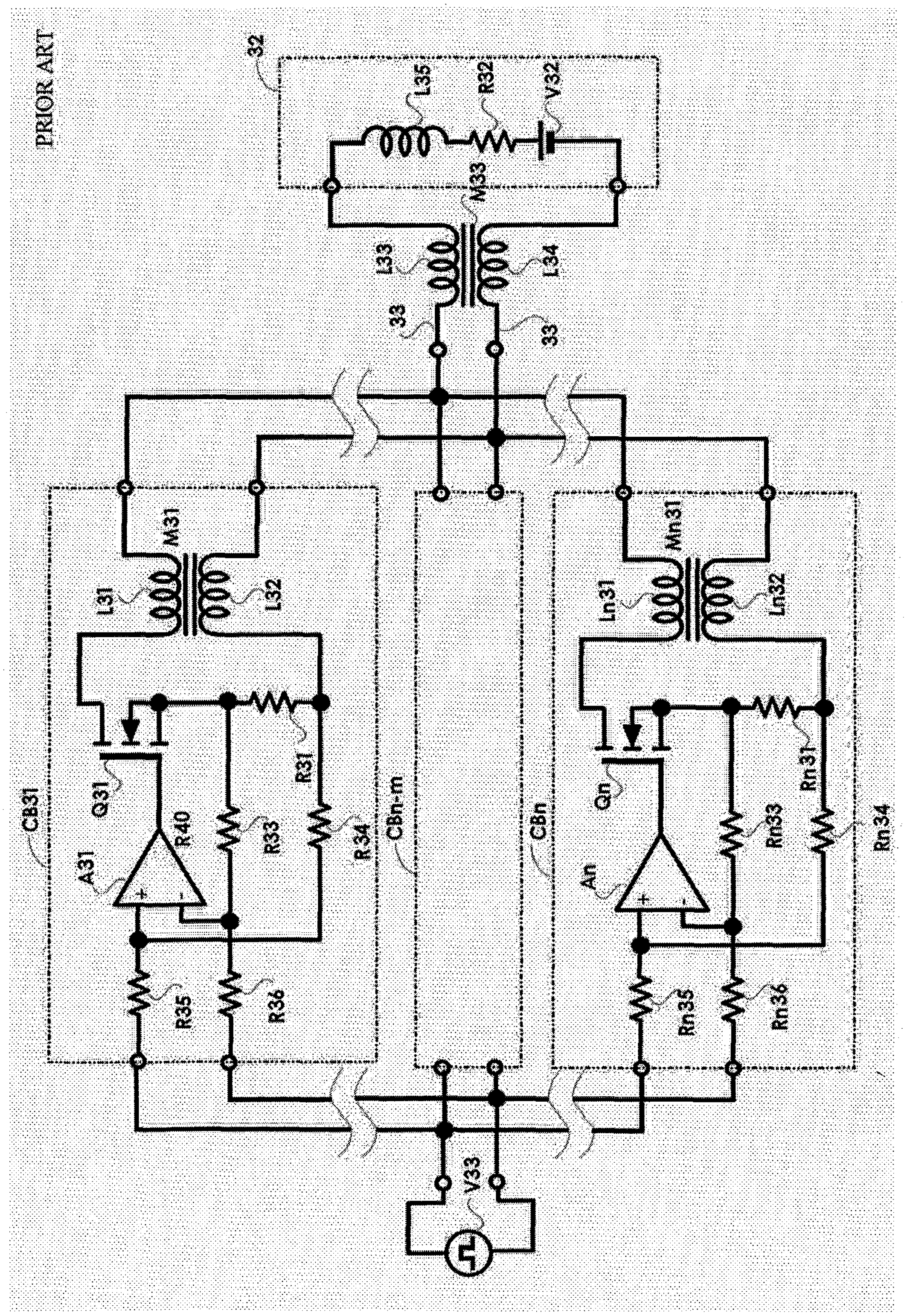
PRIOR ART
32
L35
R32
V32
M33
L33
L34
33
33
M31
L31
L32
Q31
R31
R40
R33
R34
CB31
A31
R35
R36
CBn-m
CBn
Mn31
Ln31
Ln32
Qn
Rn31
Rn33
Rn34
An
Rn35
Rn36
V33

*Fig. 6*

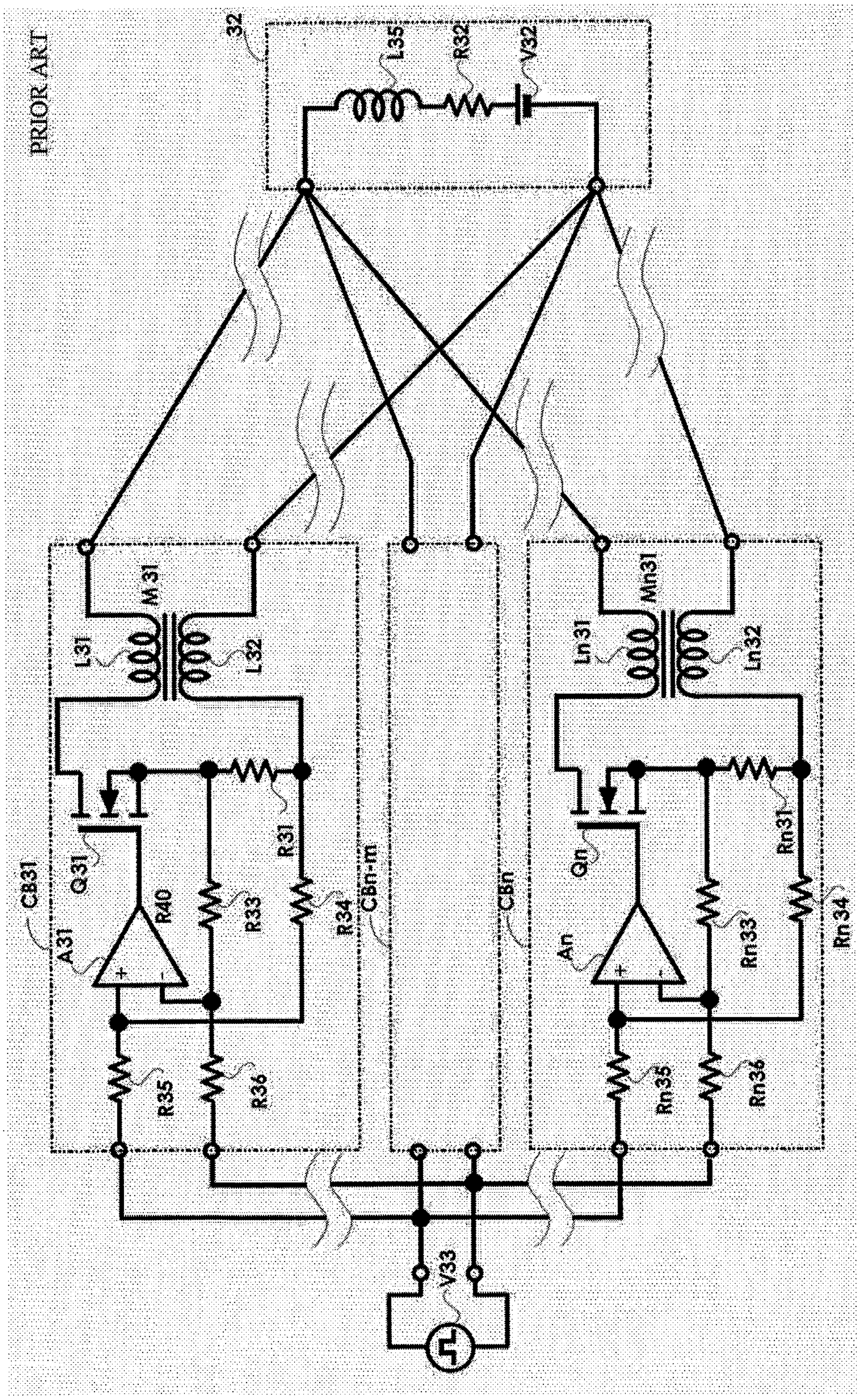
PRIOR ART
32
L35
R32
V32
M31
L31
L32
Q31
R40
R31
R33
R34
CB31
A31
R35
R36
CBn-m
CBn
Mn31
Ln31
Ln32
Qn
Rn31
An
Rn33
Rn34
Rn35
Rn36
V33

*Fig. 7*

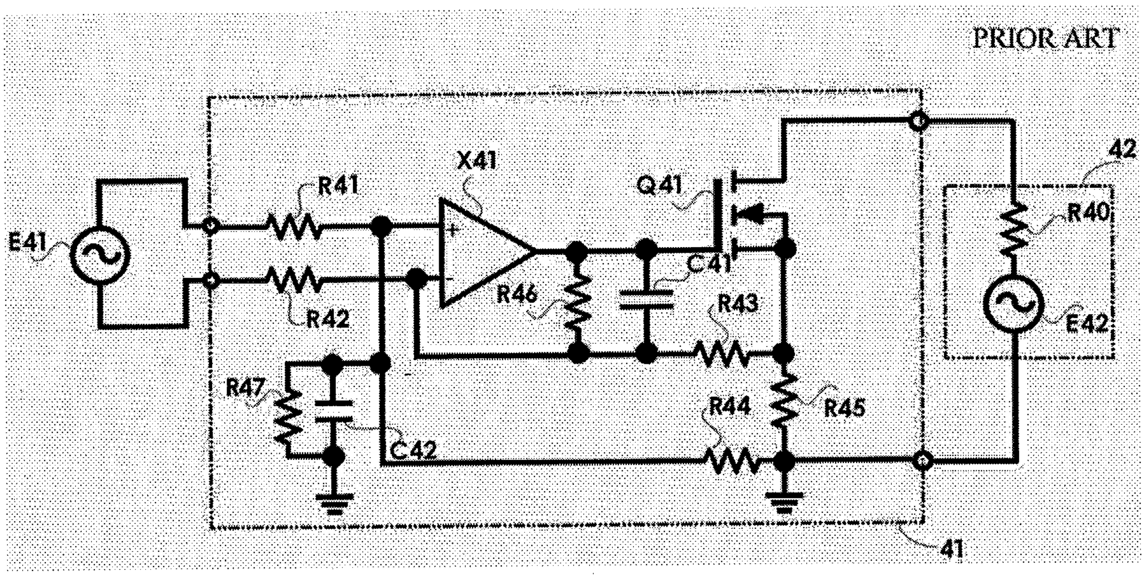
PRIOR ART
X41
R41
Q41
42
E41
R40
C41
R46
R43
R42
E42
R47
R44
R45
C42
41

*Fig. 8*

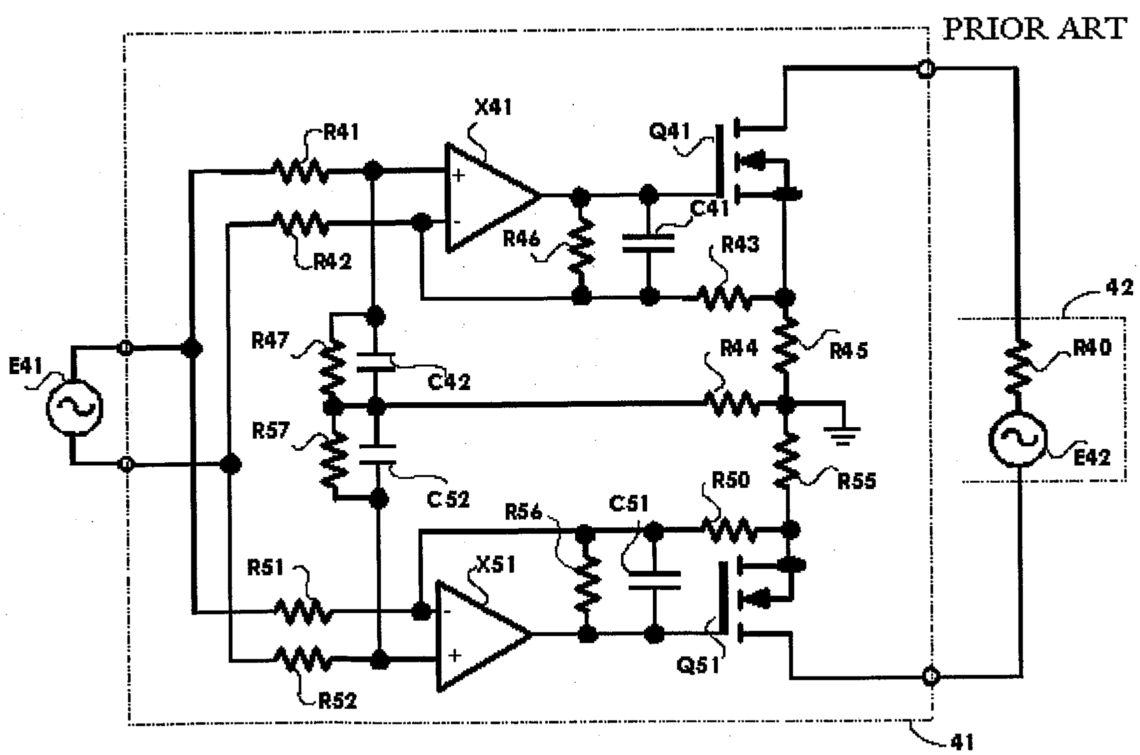
PRIOR ART
X41
R41
Q41
C41
R46
R43
R42
42
R47
R44
E41
R45
R40
C42
R57
R55
E42
R50
C52
R56
C51
R51
X51
R52
Q51
41

*Fig. 9*

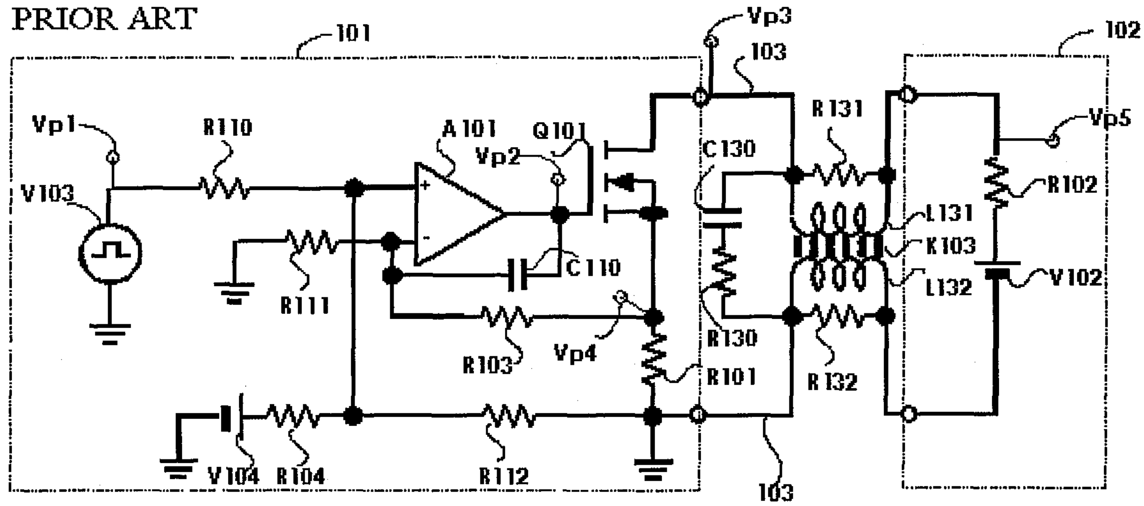
PRIOR ART
101
Vp3
103
102
Vp1
R110
A101
Q101
Vp2
C130
R131
Vp5
V103
R102
L131
K103
C110
L132
V102
R111
R130
R103
Vp4
R101
R132
V104
R104
R112
103

*Fig. 10*

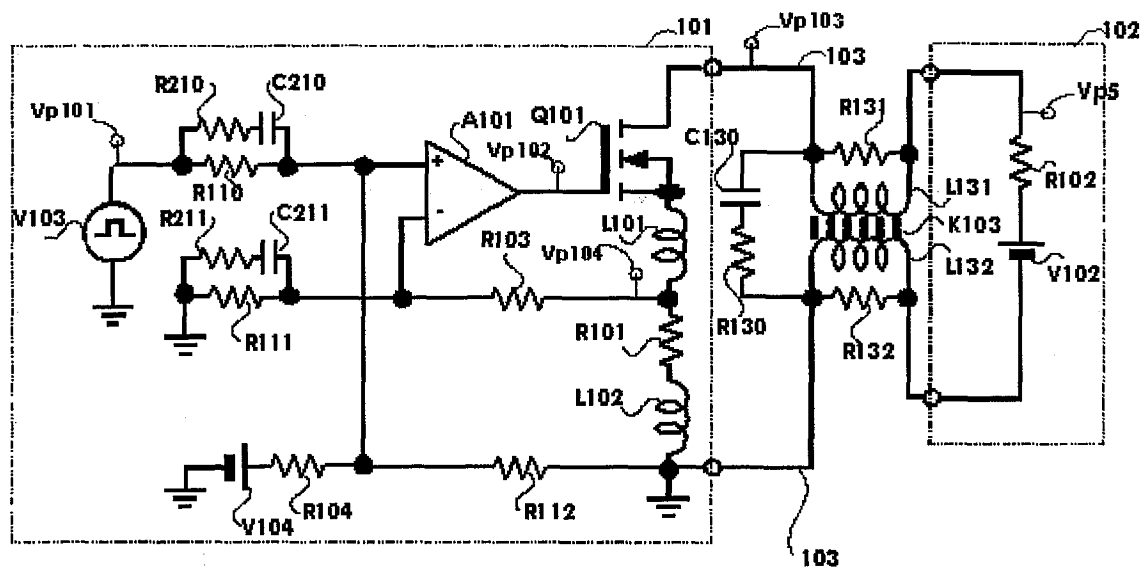
101
Vp103
102
103
R210
C210
Vp101
A101
Q101
R131
Vp5
Vp102
C130
R110
R211
C211
L131
R102
V103
K103
L101
R103
Vp104
L132
V102
R111
R130
R101
R132
L102
R104
R112
V104
103

*Fig. 11 A*

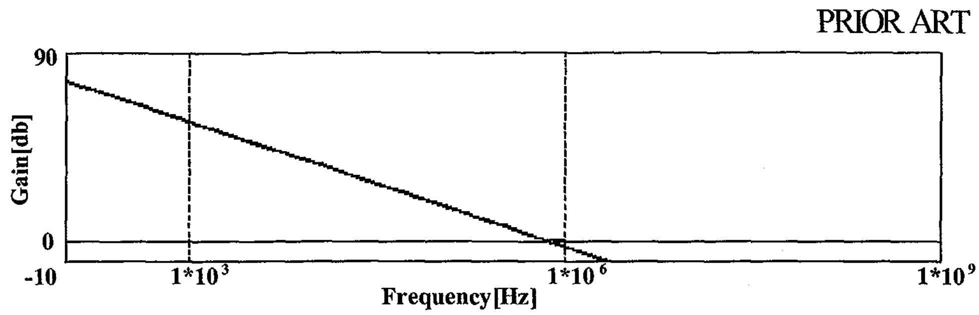


*Fig. 11 B*

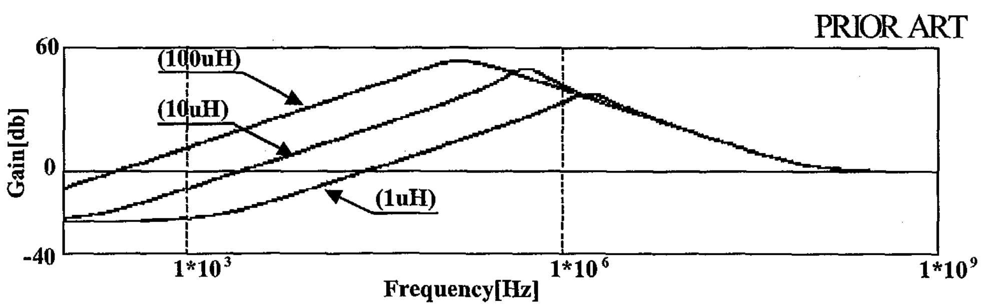


*Fig. 11 C*

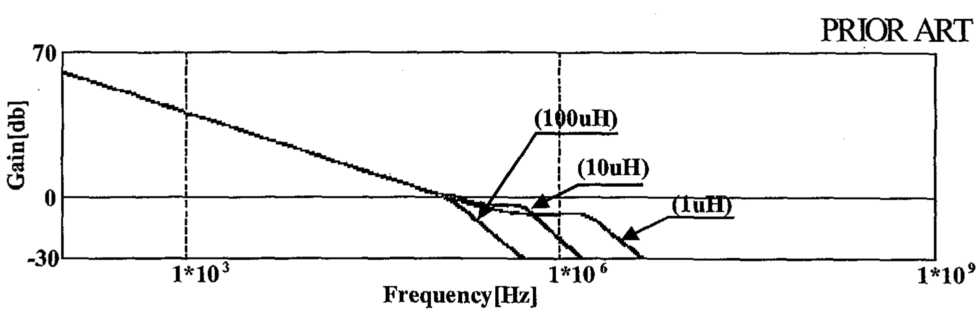


*Fig. 11 D*

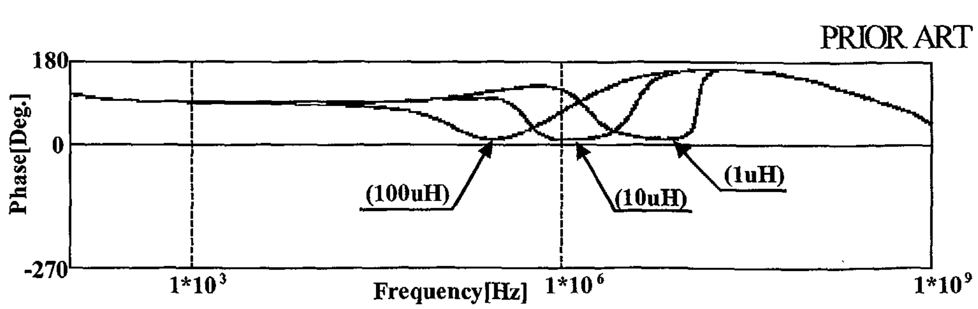

*Fig. 12 A*

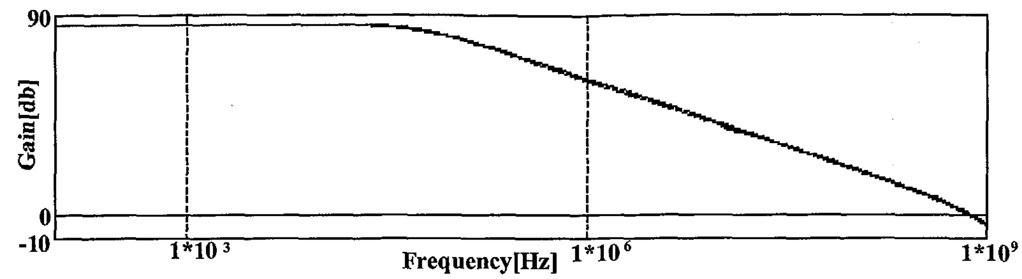


*Fig. 12 B*

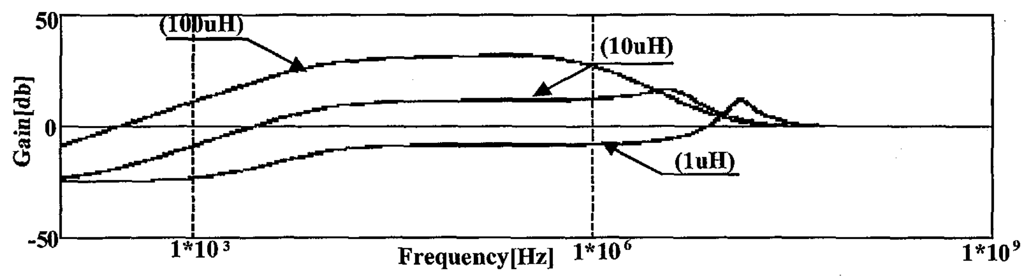


*Fig. 12 C*

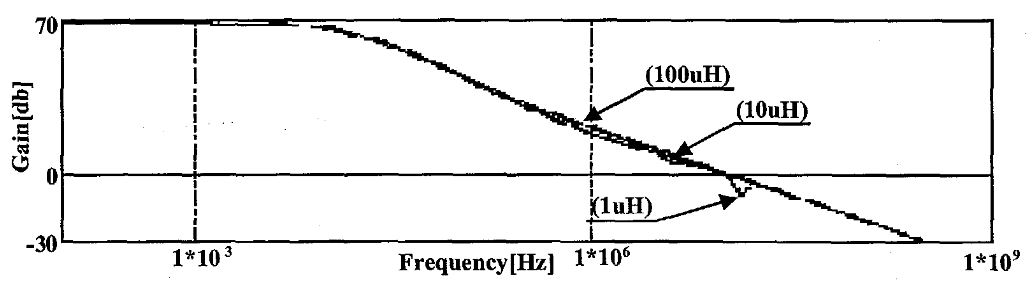


*Fig. 12 D*

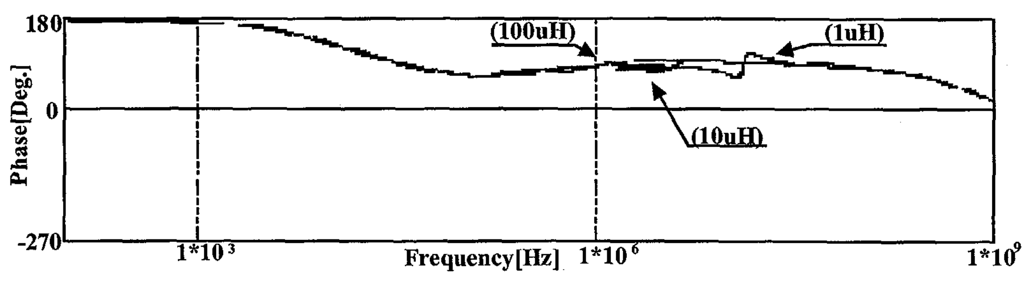

*Fig. 13*

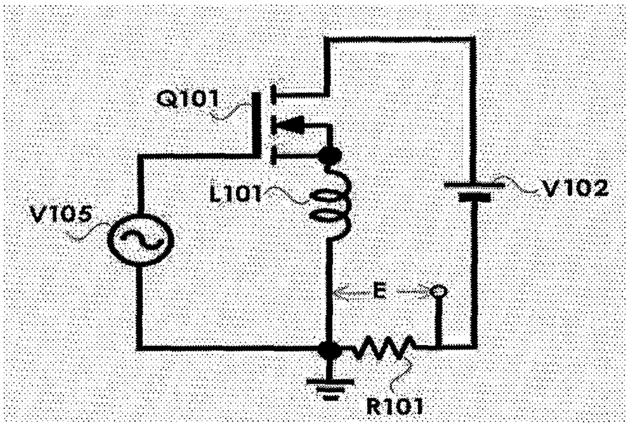


*Fig. 14*

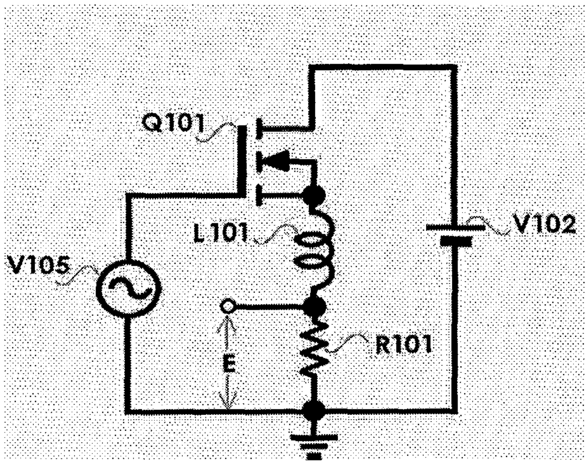

*Fig. 15 A*

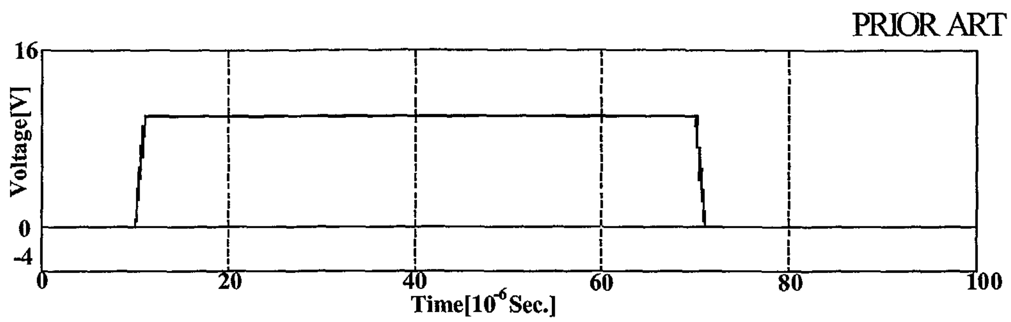


*Fig. 15 B*

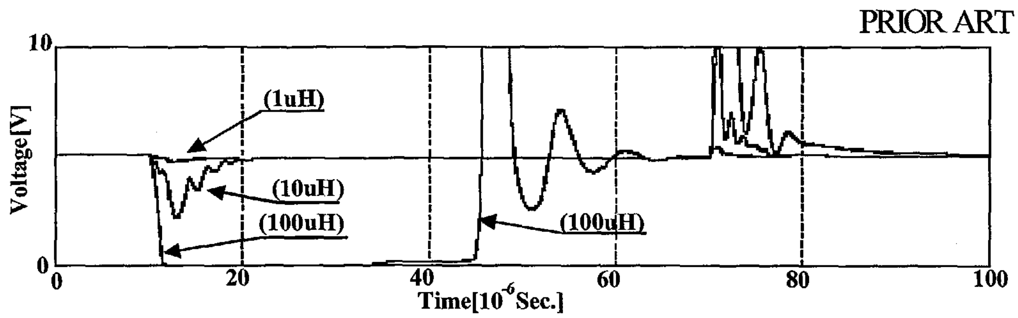


*Fig. 15 C*

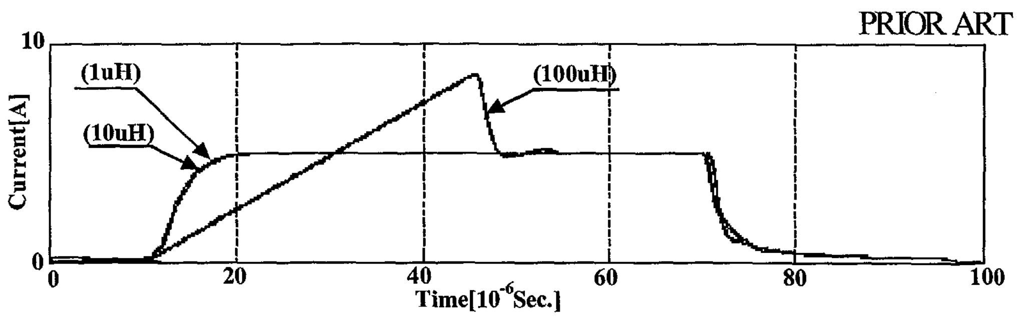

*Fig. 16 A*

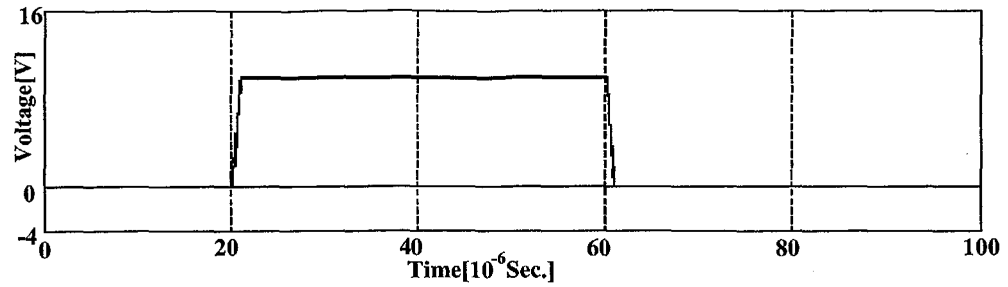


*Fig. 16 B*

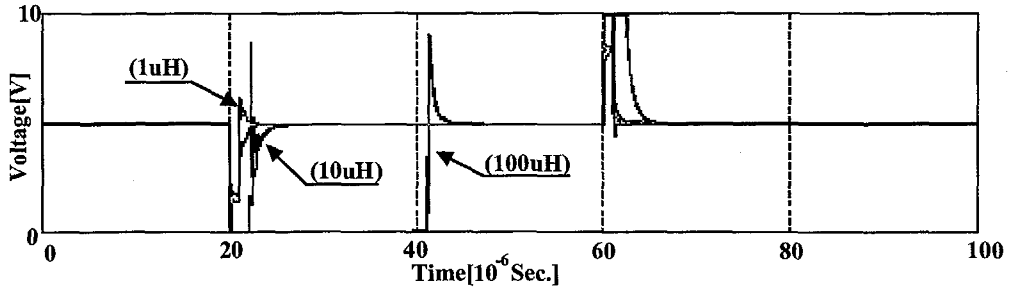


*Fig. 16 C*

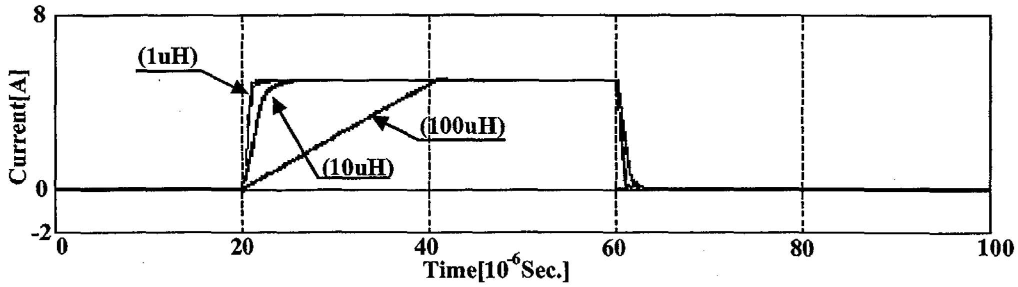

*Fig. 17*

PRIOR ART

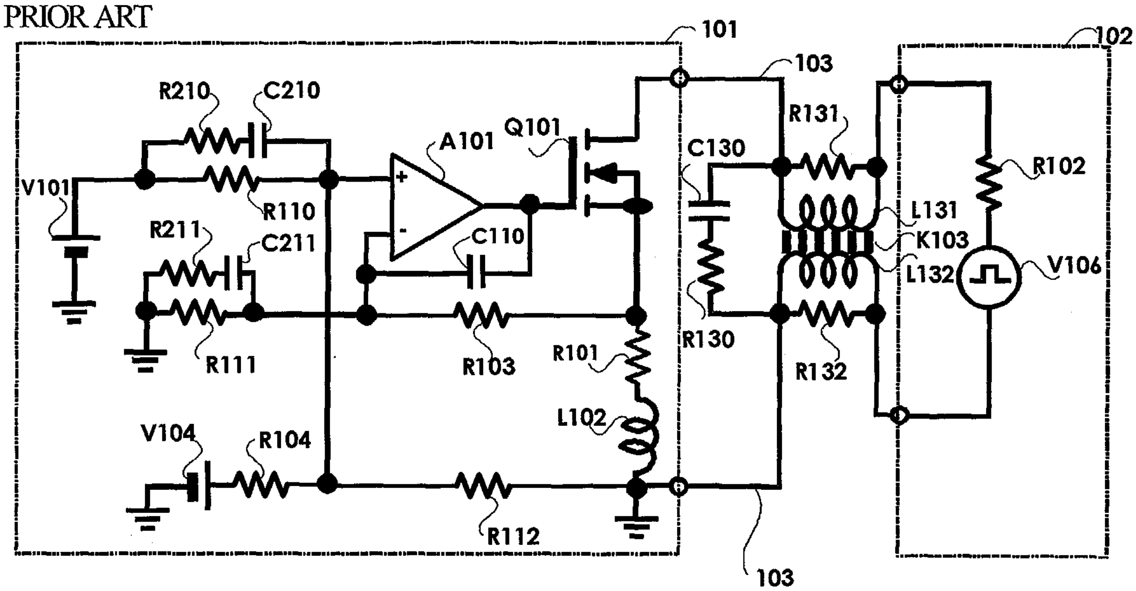


*Fig. 18*

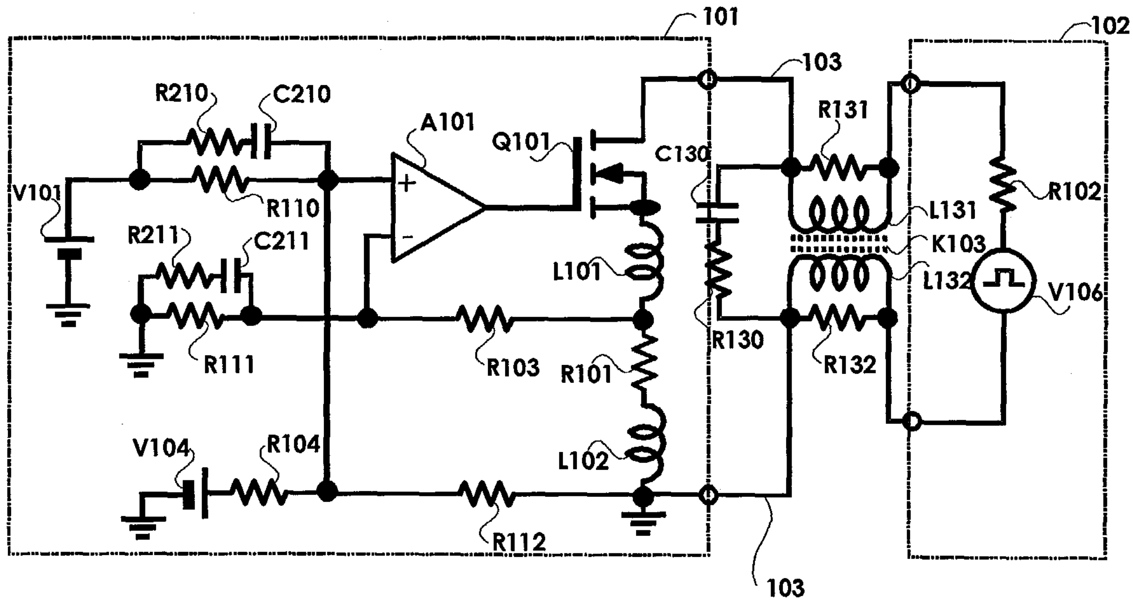

*Fig. 19 A*

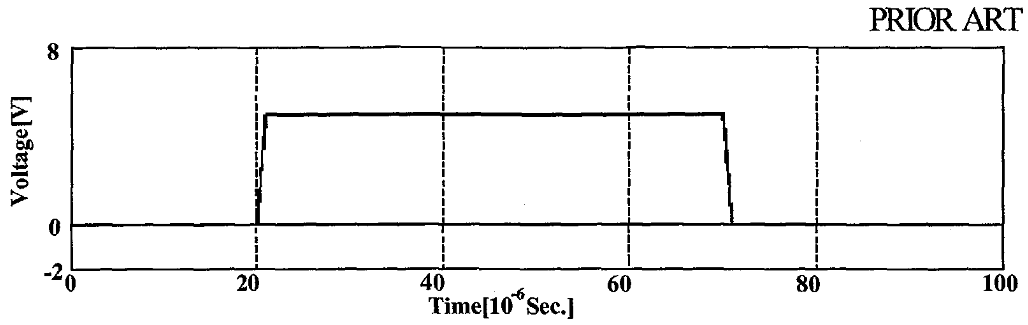


*Fig. 19 B*

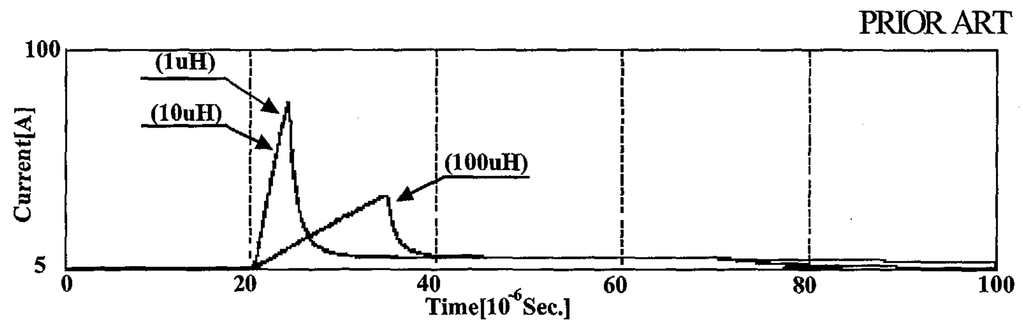


*Fig. 20 A*

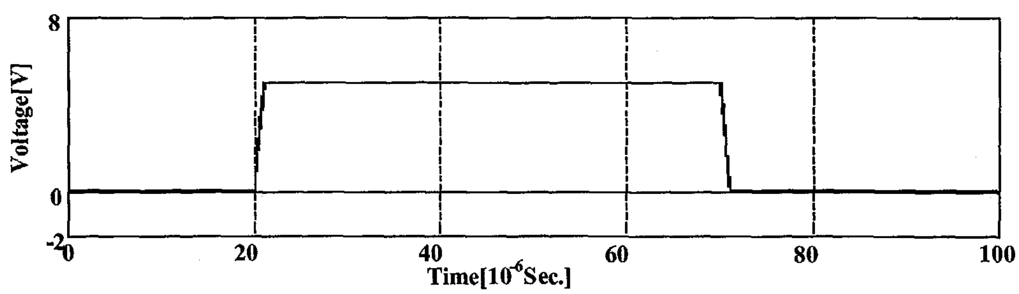


*Fig. 20 B*

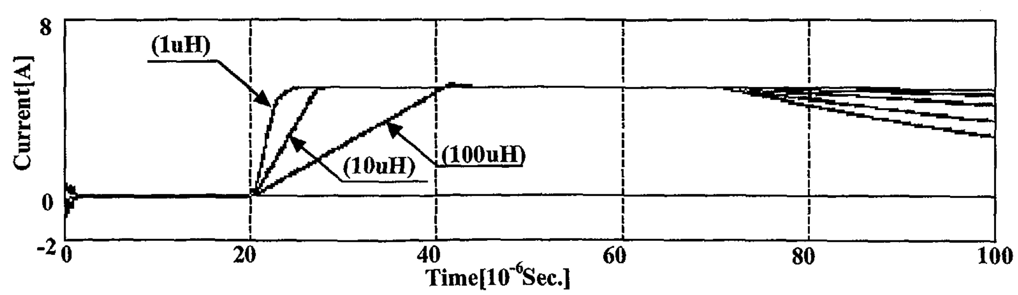

*Fig.21*

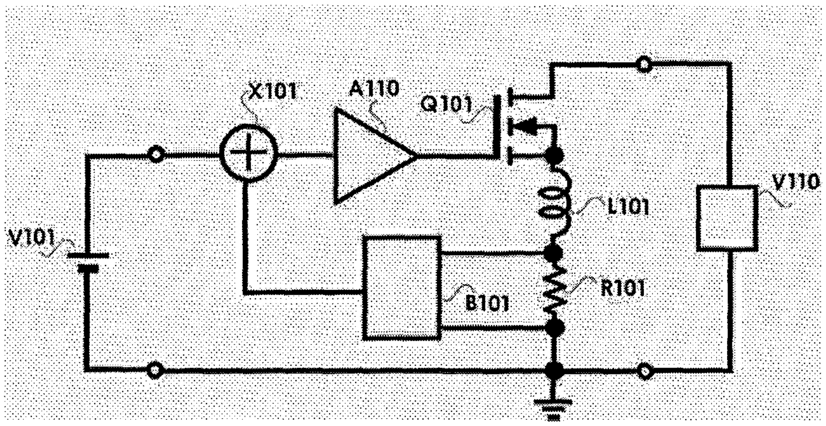


*Fig. 22*

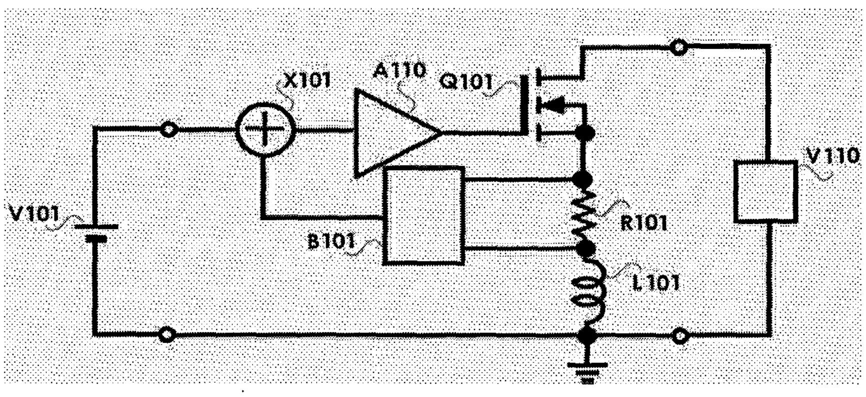


*Fig. 23*

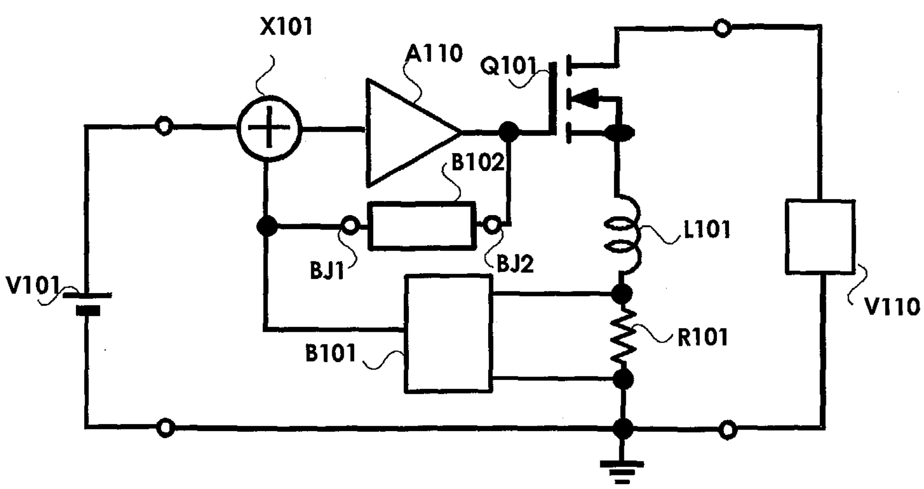

Fig. 24

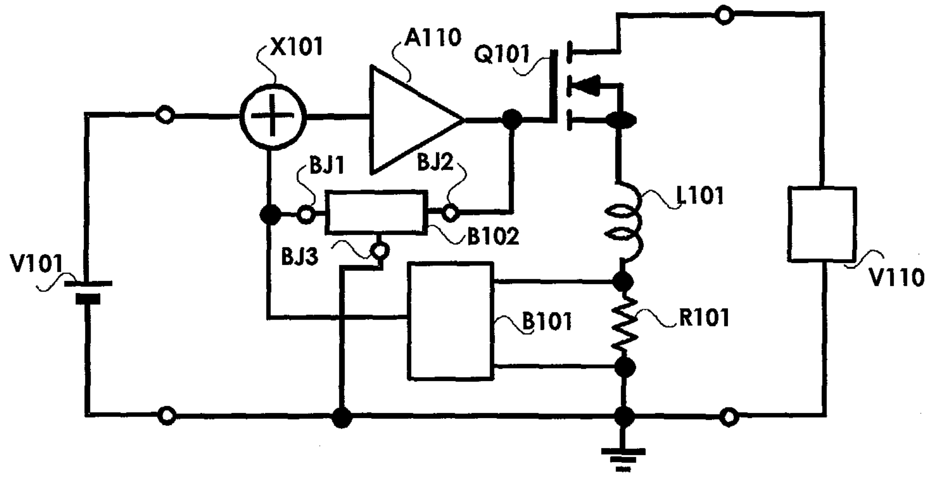


Fig. 25 A

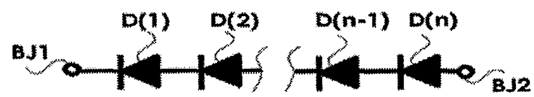


Fig. 25 B

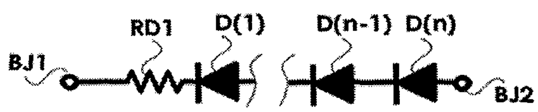


Fig. 25 C

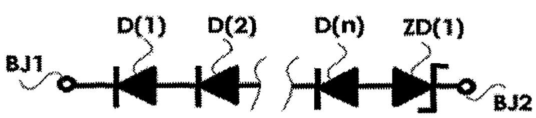


Fig. 25 D

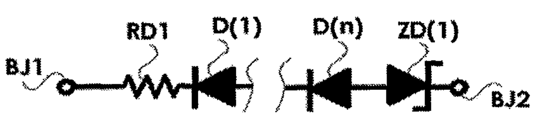

*Fig. 26 A*

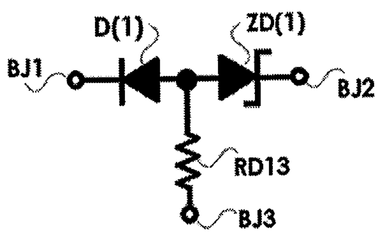


*Fig. 26 B*

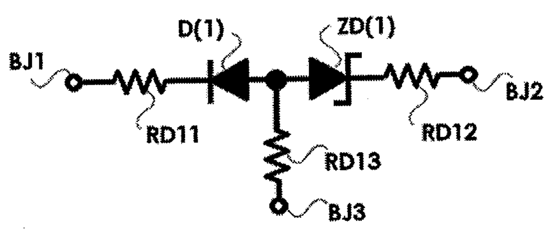


*Fig. 26 C*

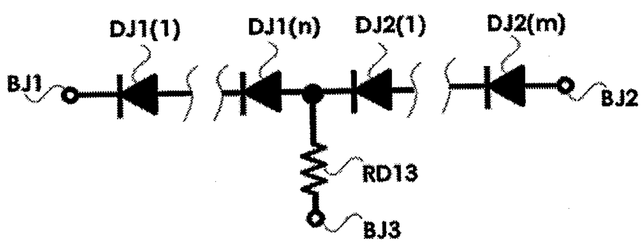


*Fig. 26 D*

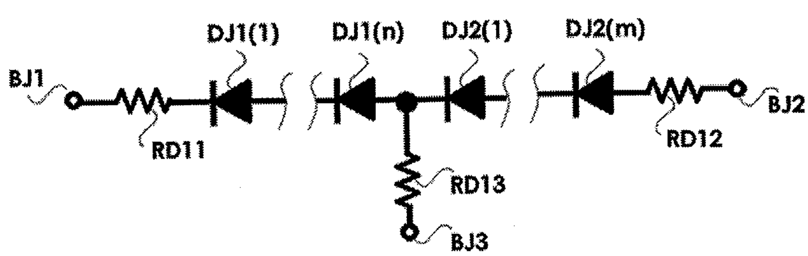

*Fig. 27*

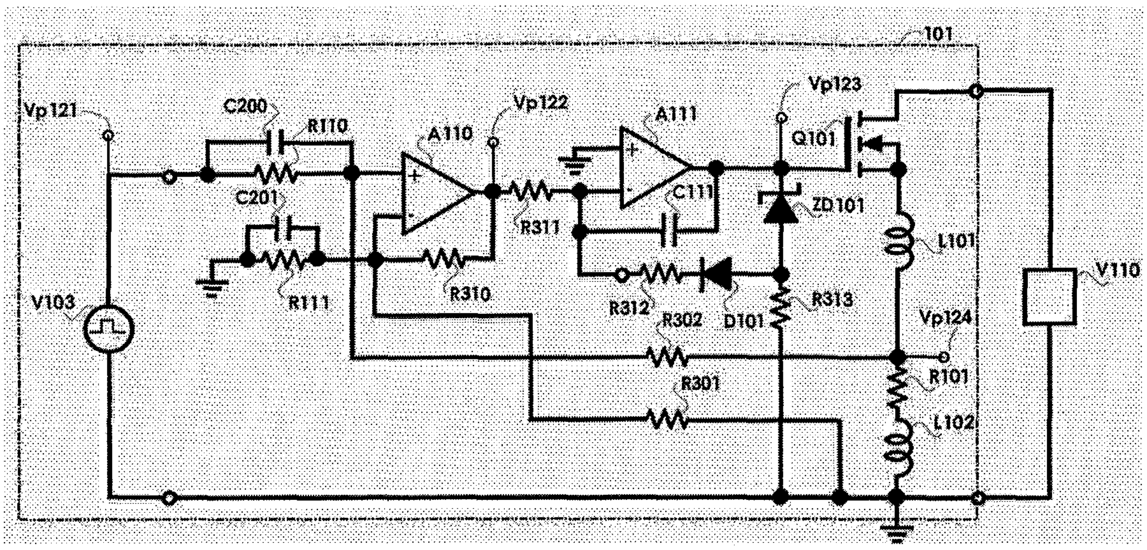


*Fig. 28 A*

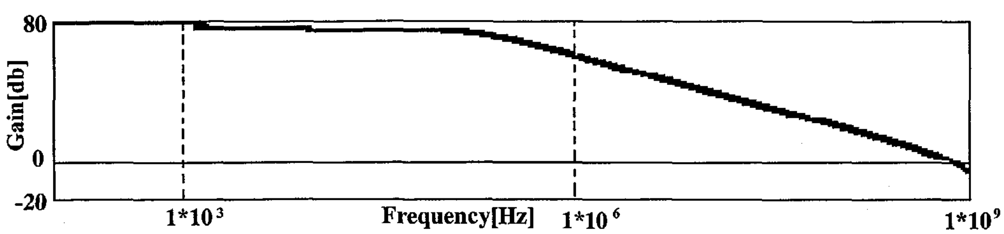


*Fig. 28 B*

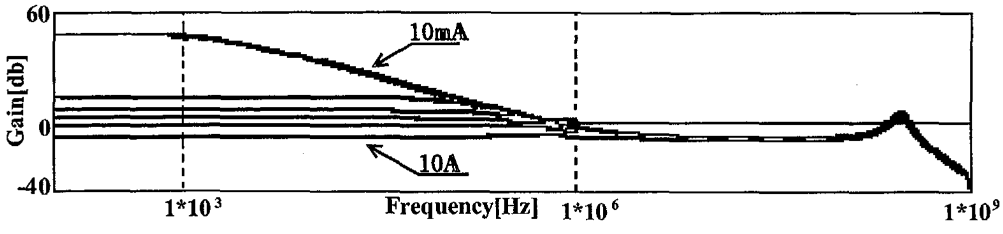

*Fig. 28 C*

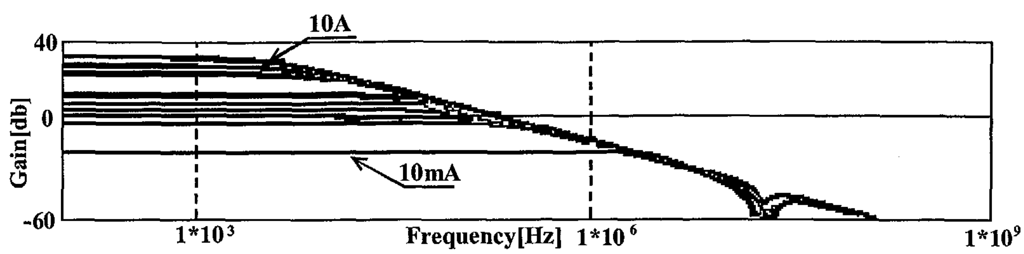


*Fig. 28 D*

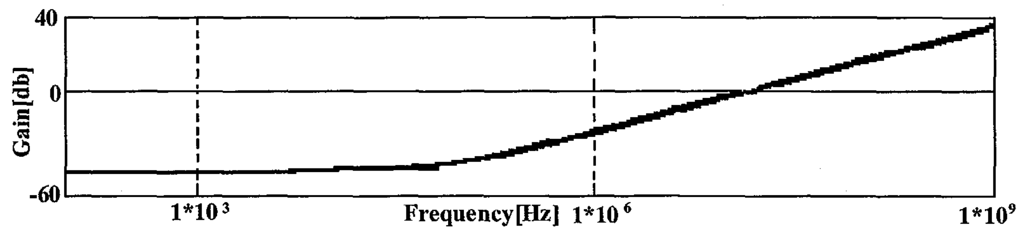


*Fig.28 E*

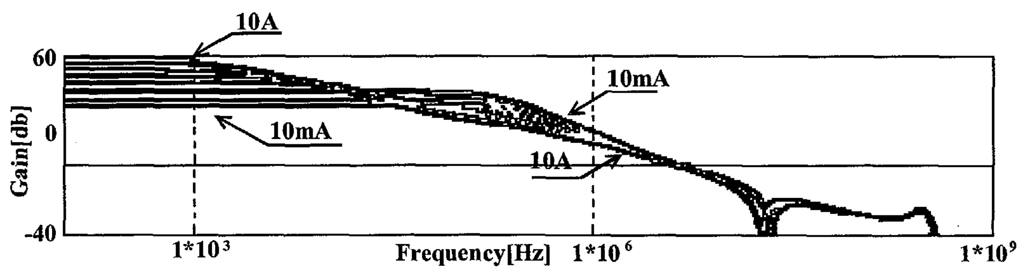


*Fig. 28 F*

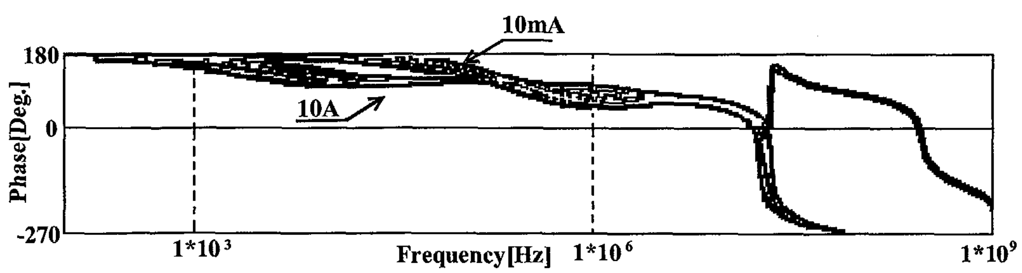

*Fig. 29*

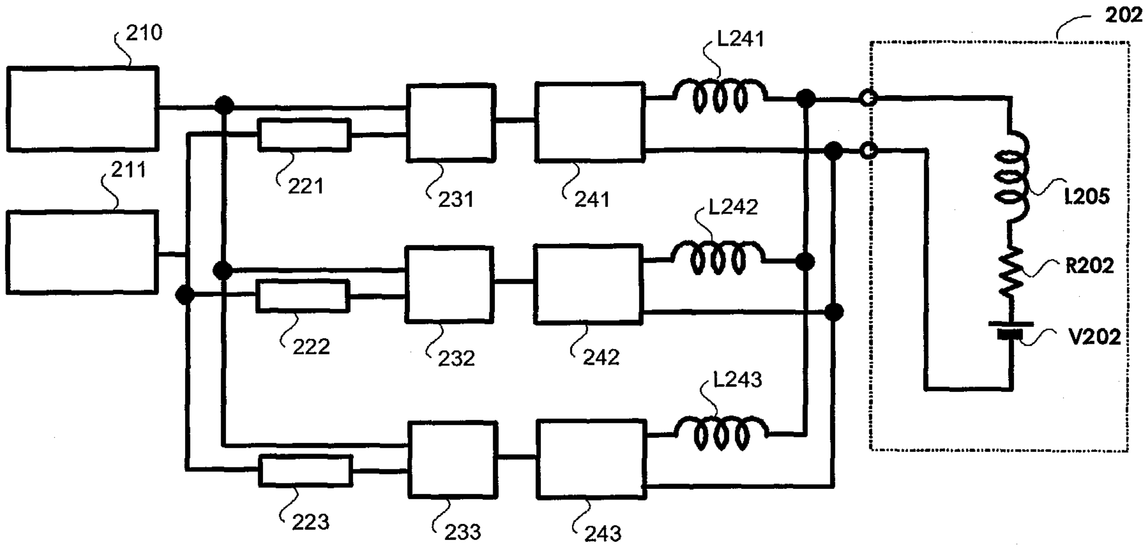
210
211
221
231
241
L241
202
L205
R202
V202
L242
222
232
242
L243
223
233
243

*Fig. 30 A*

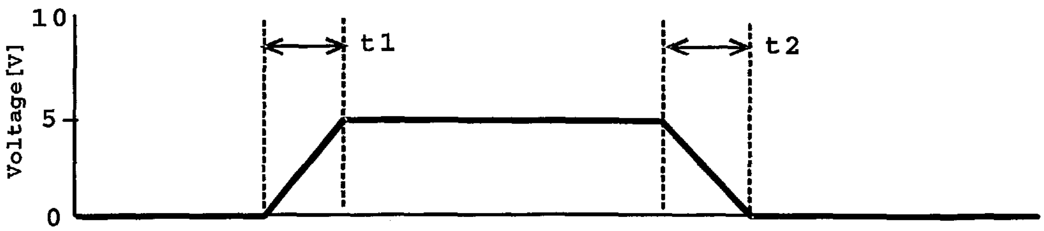


*Fig 30 B*

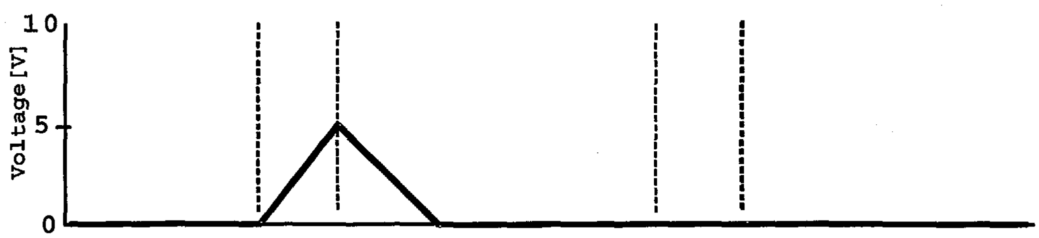


*Fig. 30 C*

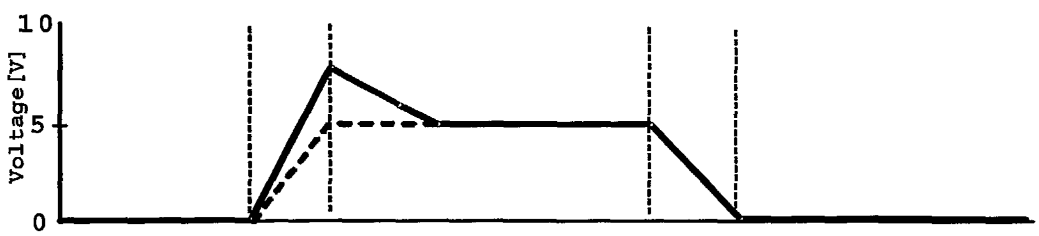


*Fig 30 D*

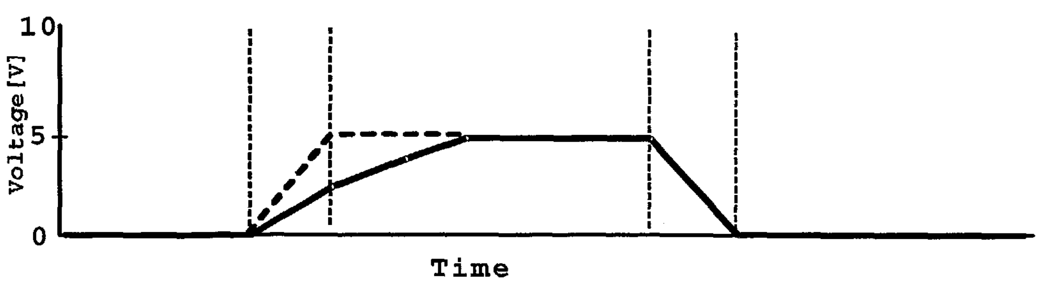

*Fig. 31*

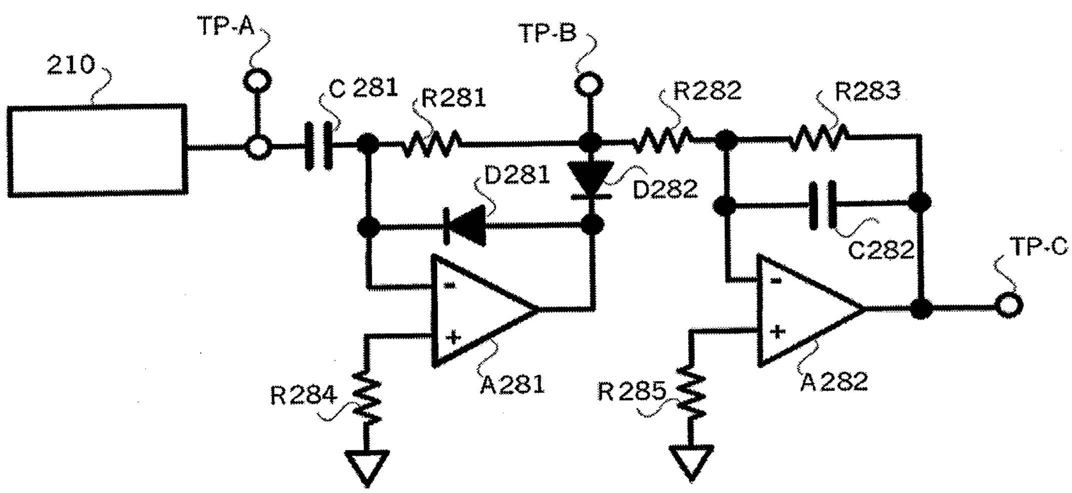
210
TP-A
C 281
R281
TP-B
R282
R283
D281
D282
C282
TP-C
A281
A282
R284
R285

*Fig. 32 A*

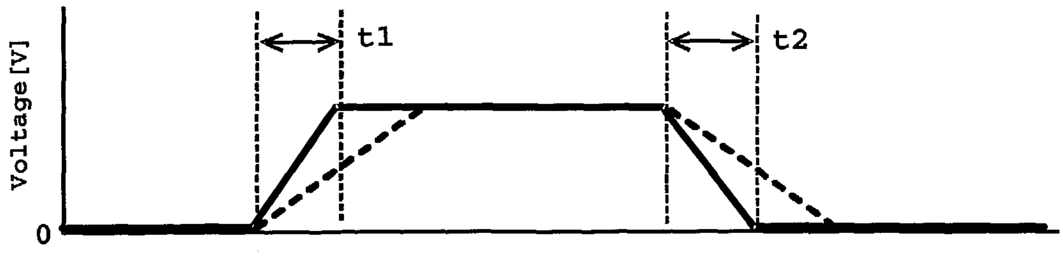


*Fig. 32 B*

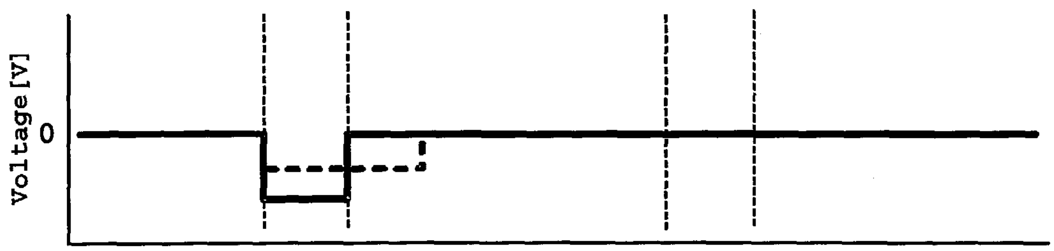


*Fig. 32 C*

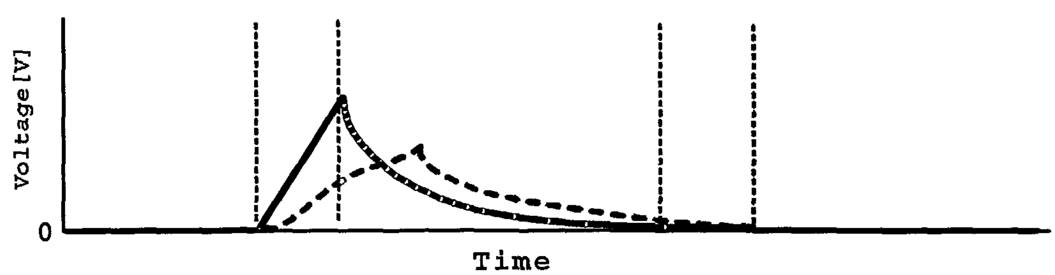

*Fig. 33*

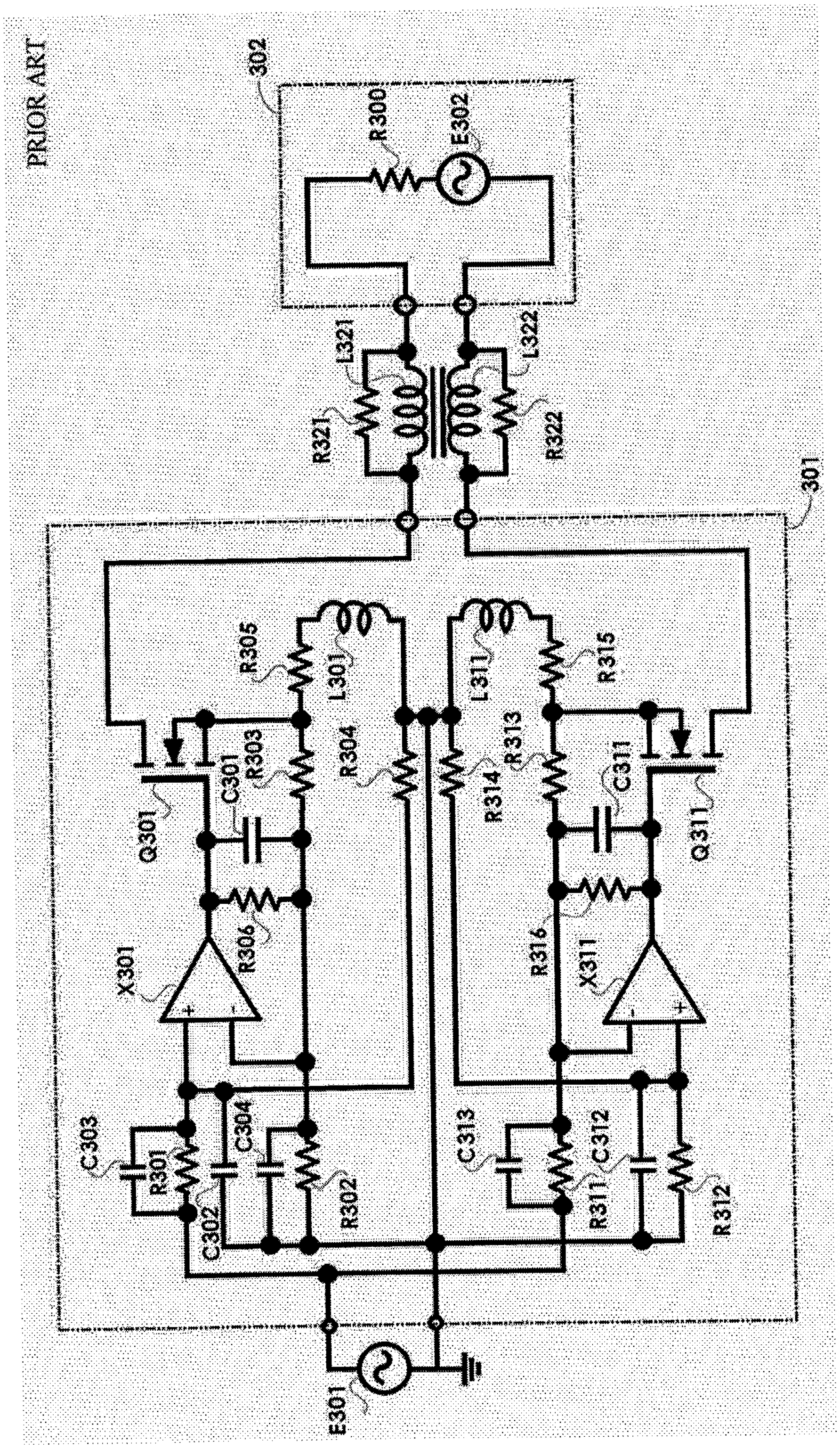
PRIOR ART
302
R300
E302
L321
L322
R321
R322
301
R305
L301
L311
R315
R304
R303
C301
R313
R314
C311
Q301
Q311
R306
R316
X301
X311
C303
C304
C313
C312
R301
R302
R311
R312
C302
E301

*Fig. 34*

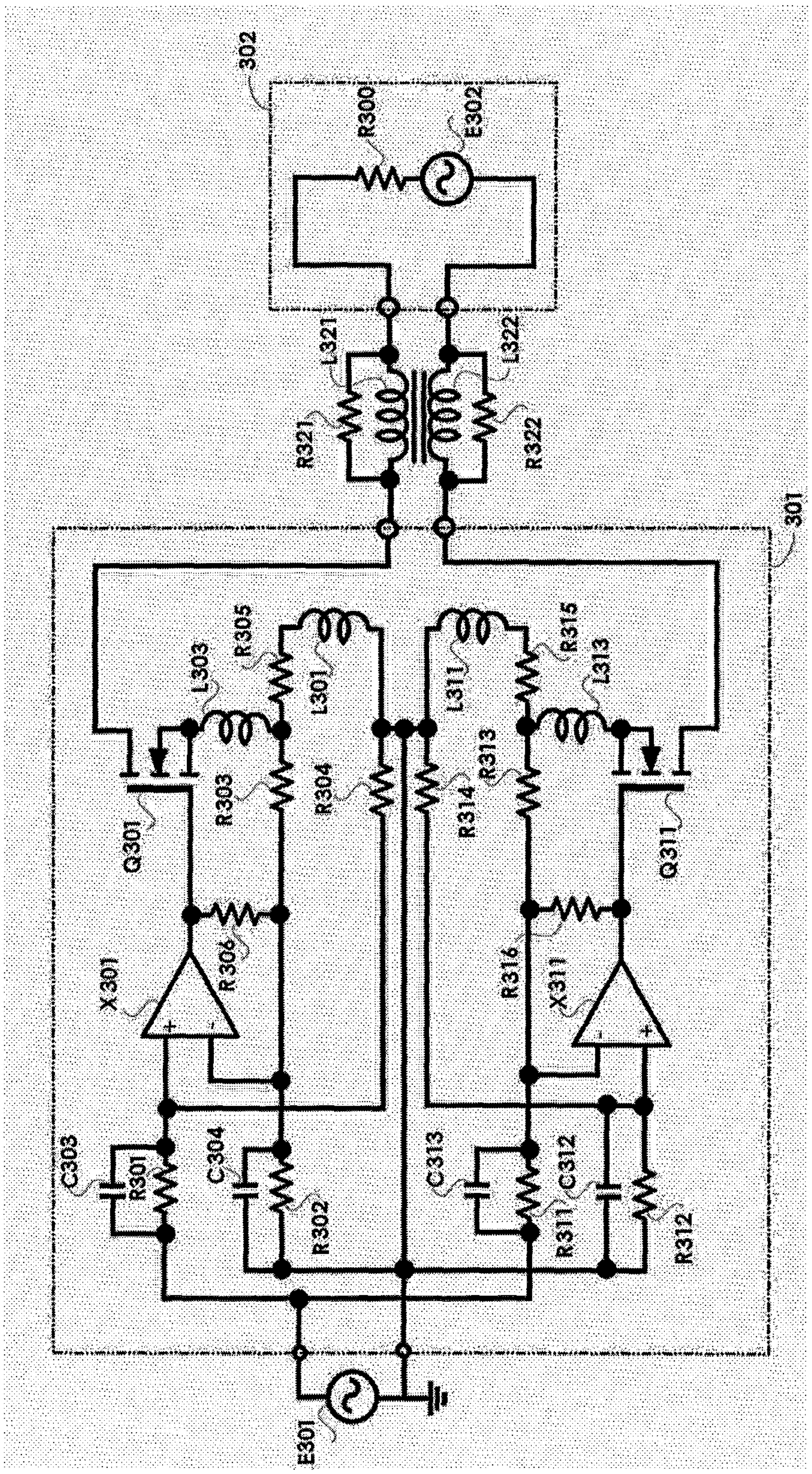
302
R300
E302
L321
L322
R321
R322
301
R305
L303
L301
L311
R315
L313
Q301
R303
R304
R314
R313
Q311
R306
X301
R316
X311
C303
R301
C304
R302
C313
R311
C312
R312
E301

*Fig. 35 A*

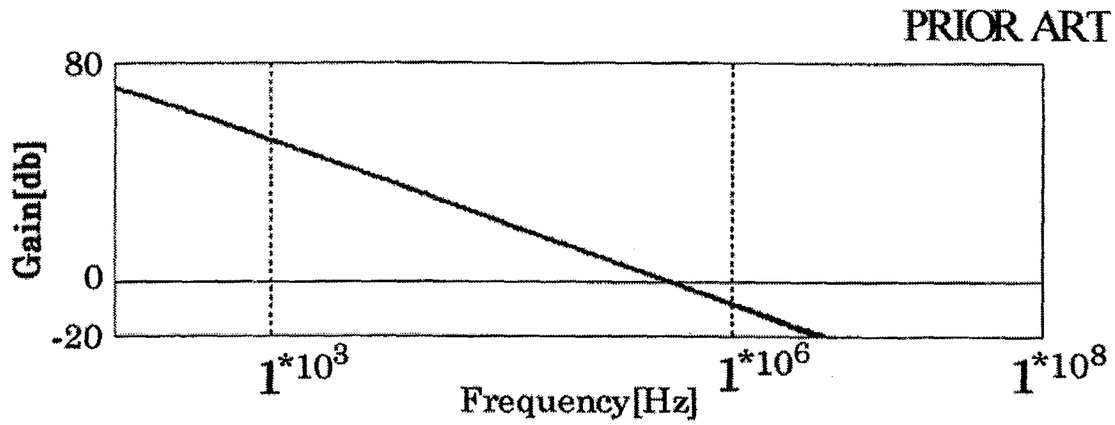


*Fig. 35 B*

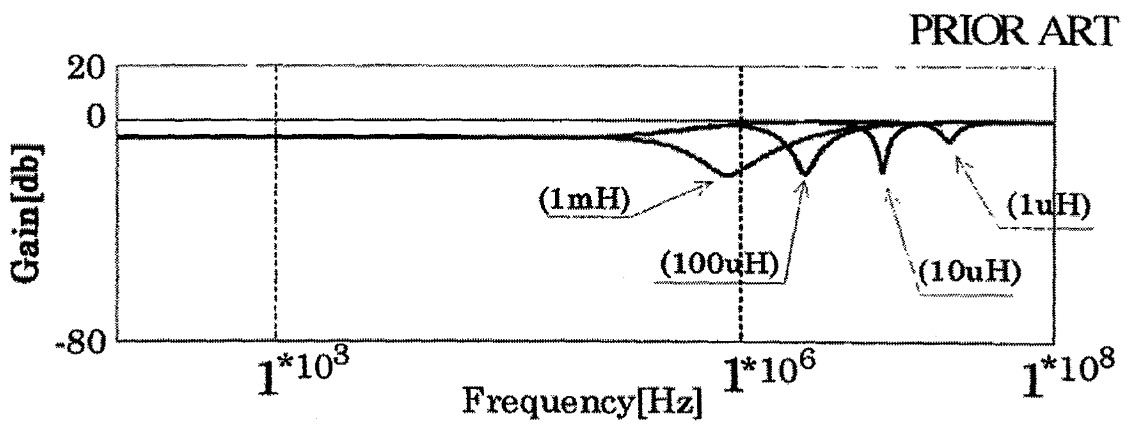


*Fig. 35 C*

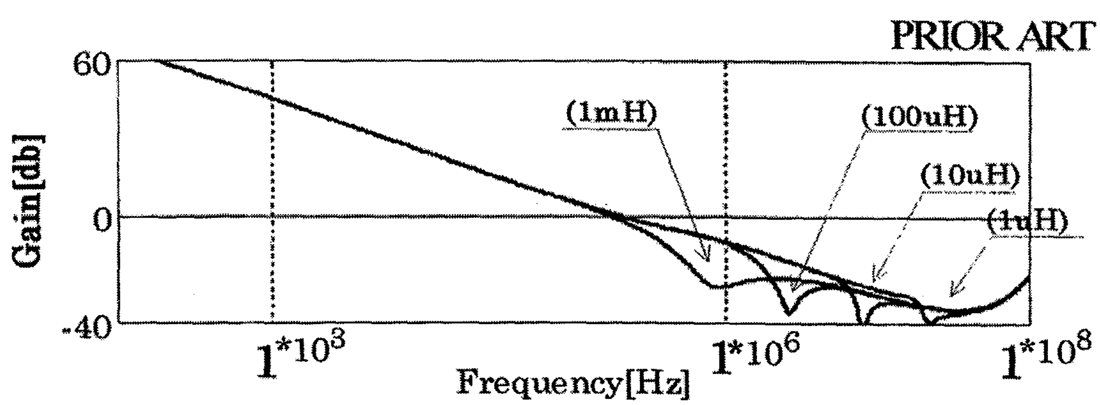

*Fig 35 D*

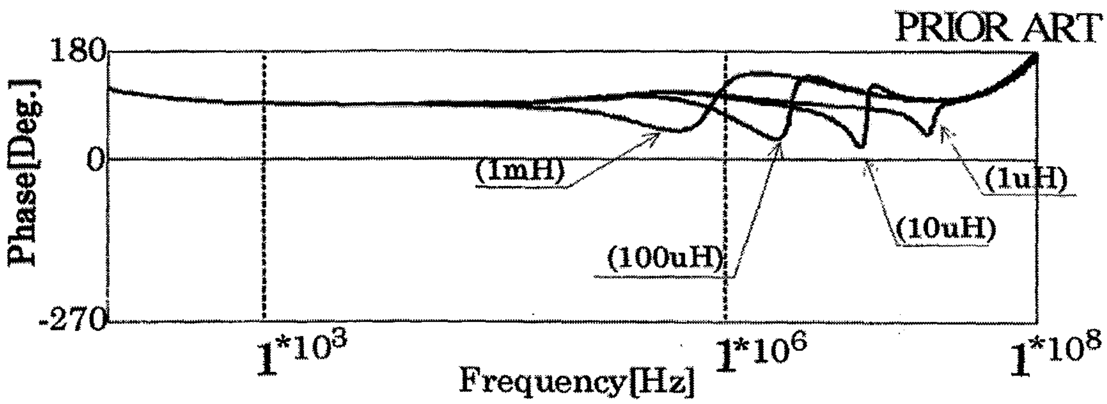


*Fig. 36 A*

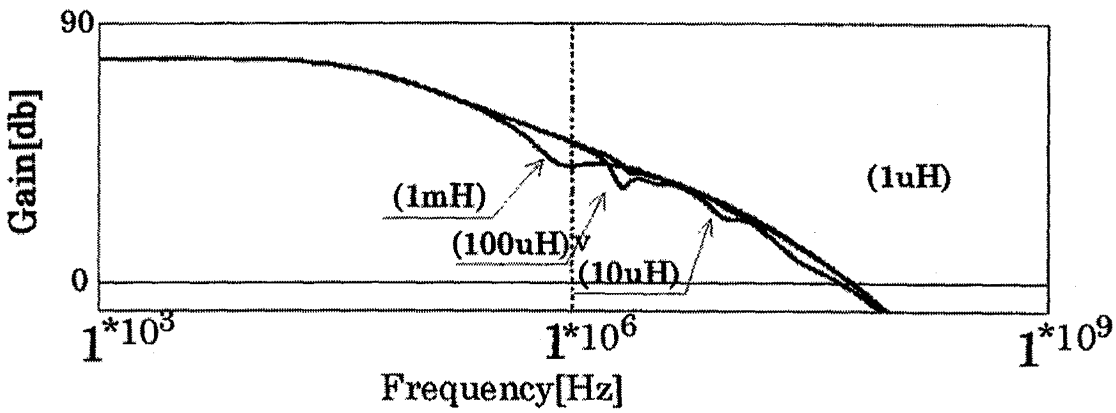


*Fig. 36 B*

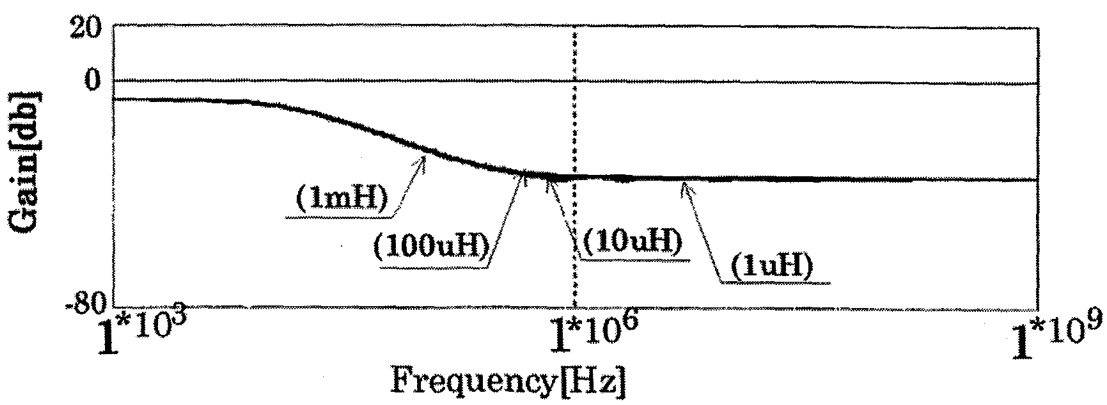

*Fig. 36 C*

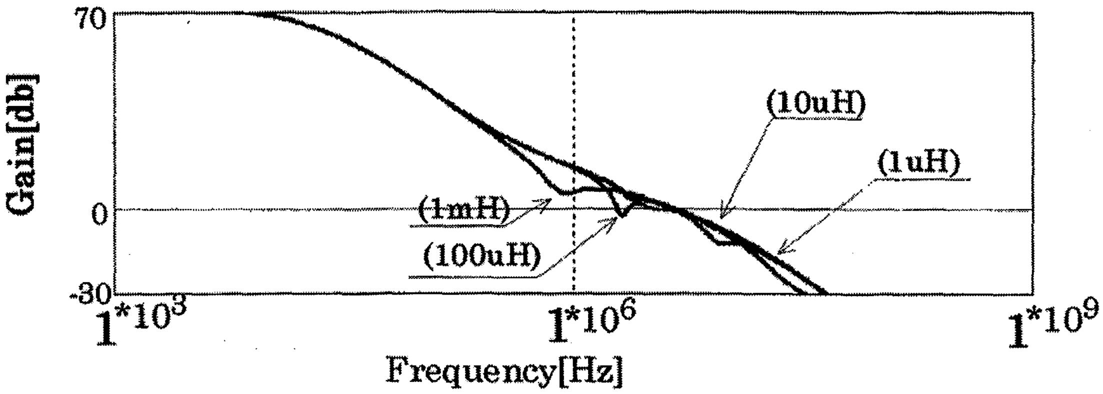


*Fig. 36 D*

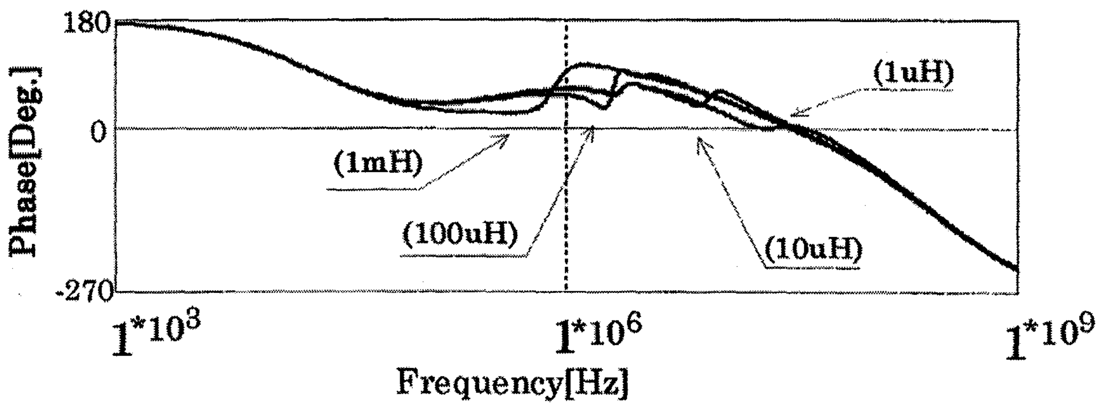

*Fig. 37 A*

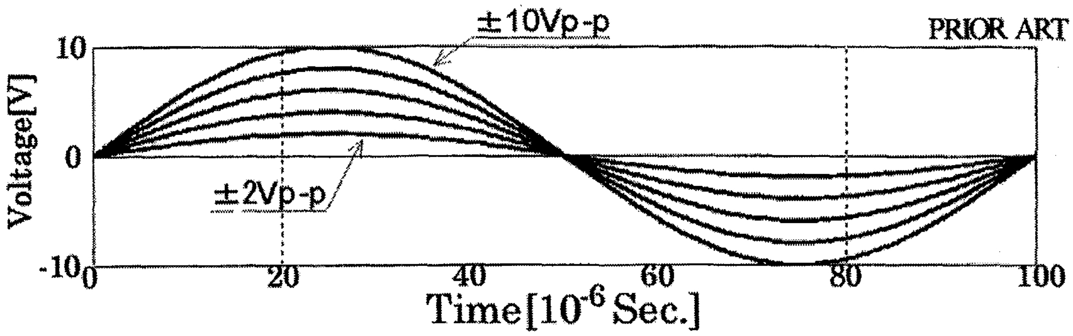


*Fig. 37 B*

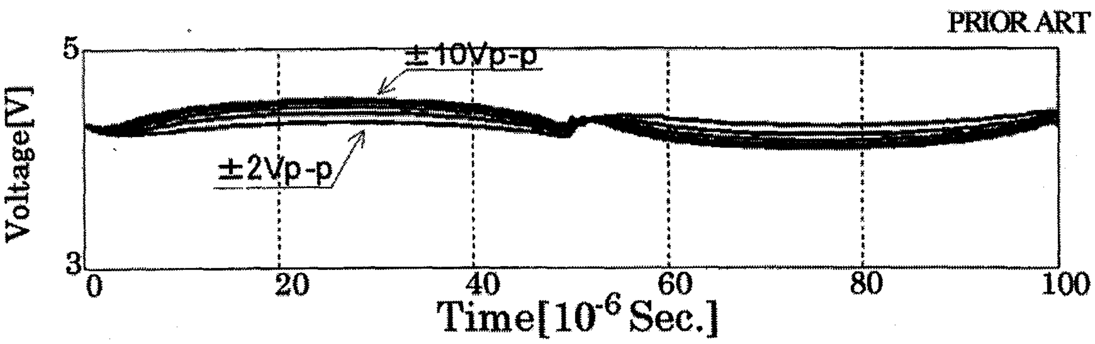


*Fig. 37 C*

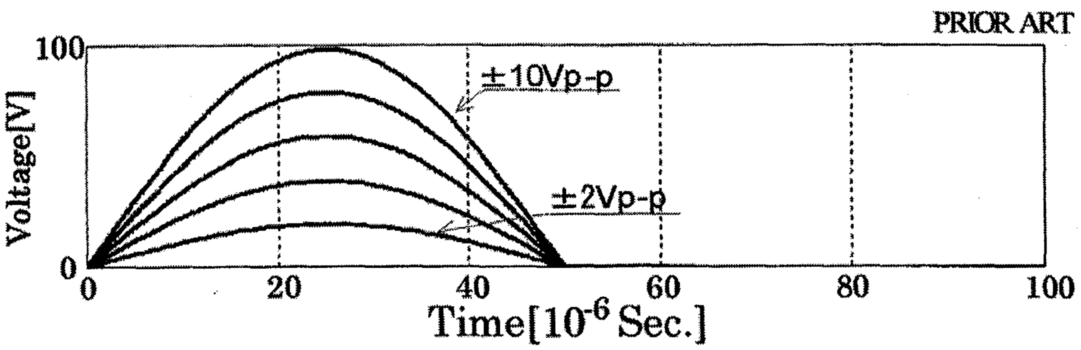

*Fig.37 D*

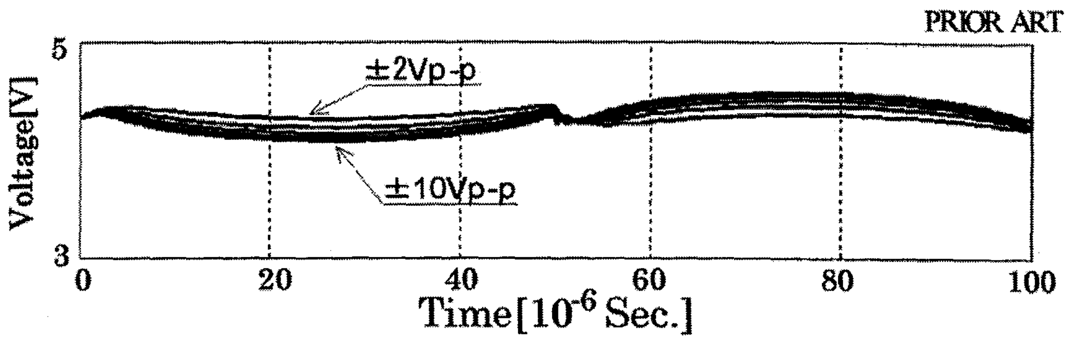


*Fig. 37 E*

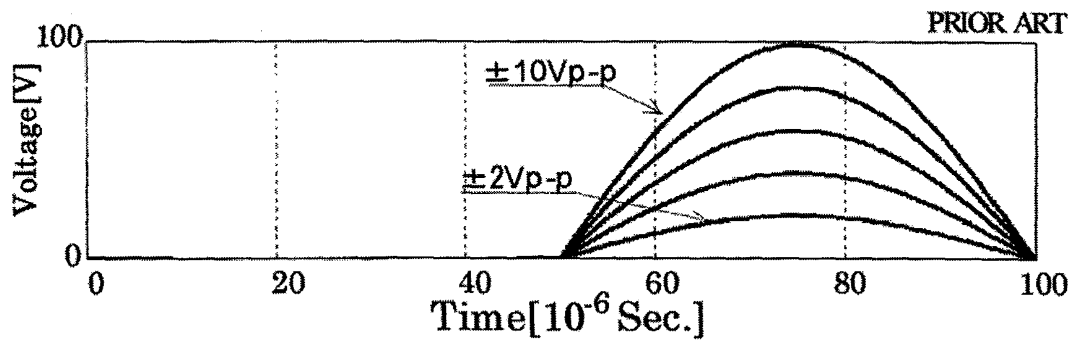


*Fig. 37 F*

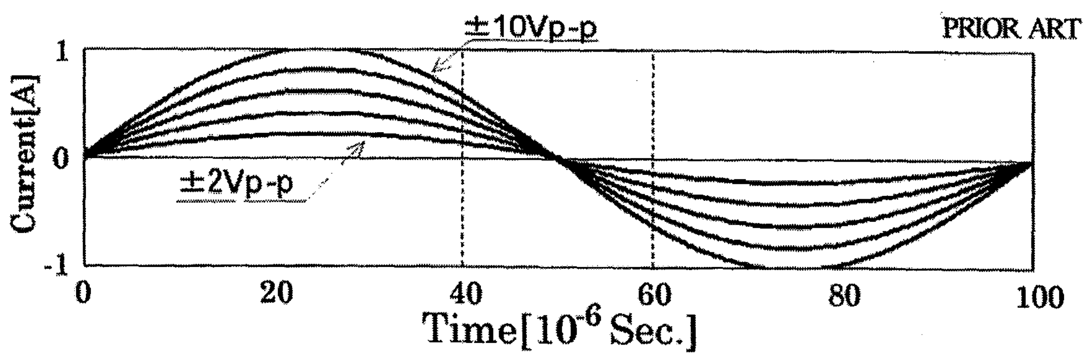

*Fig. 38 A*

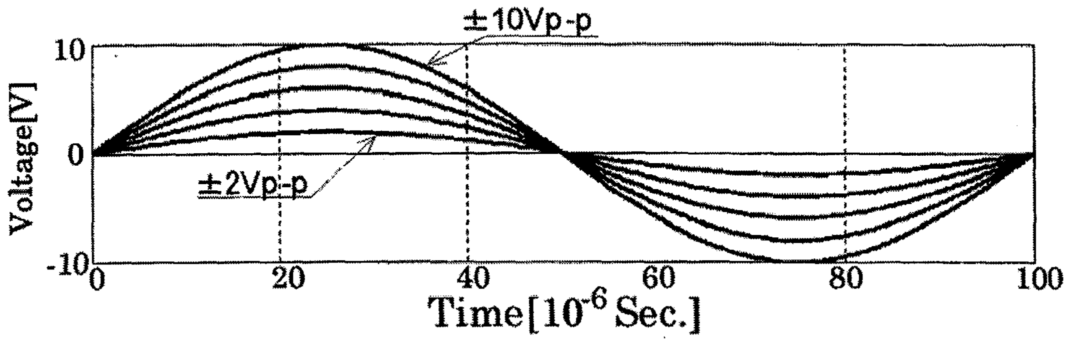


*Fig 38 B*

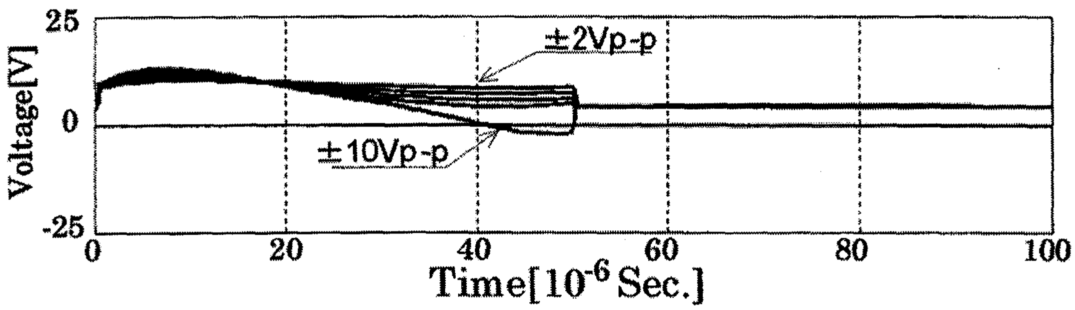


*Fig. 38 C*

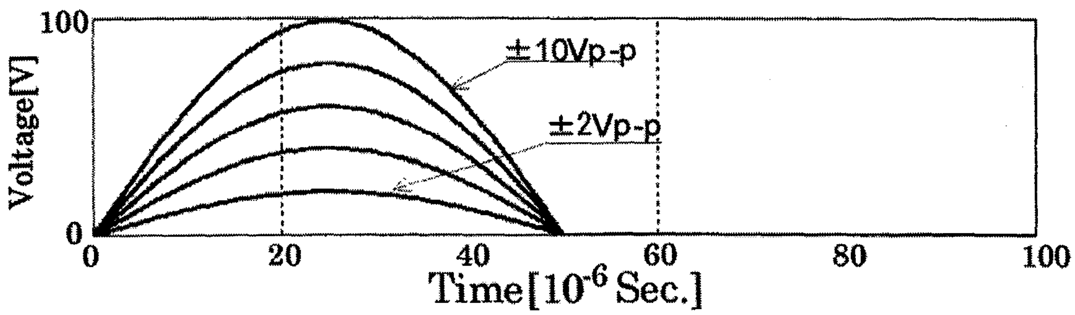

*Fig. 38 D*

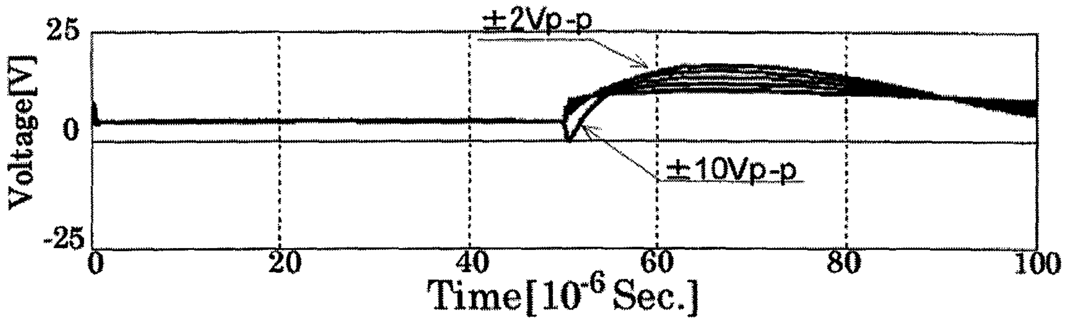


*Fig. 38 E*

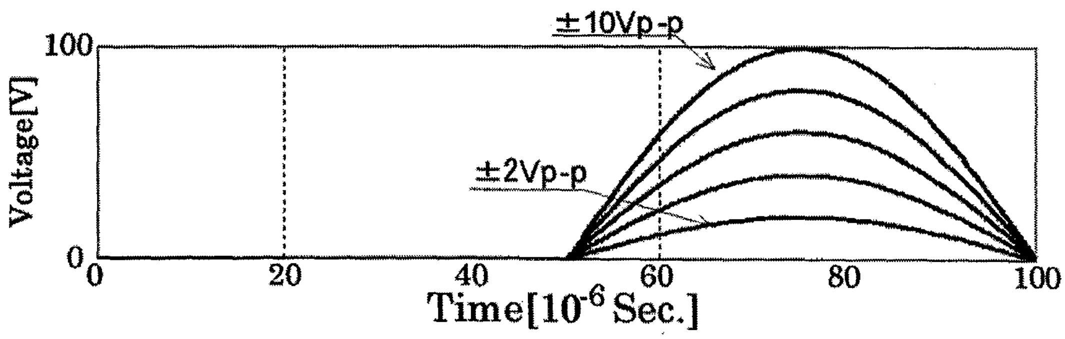


*Fig. 38 F*

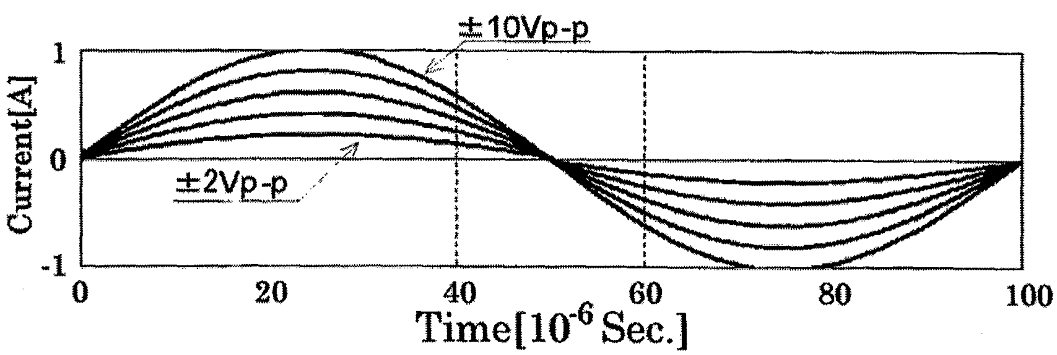

*Fig. 39 A*

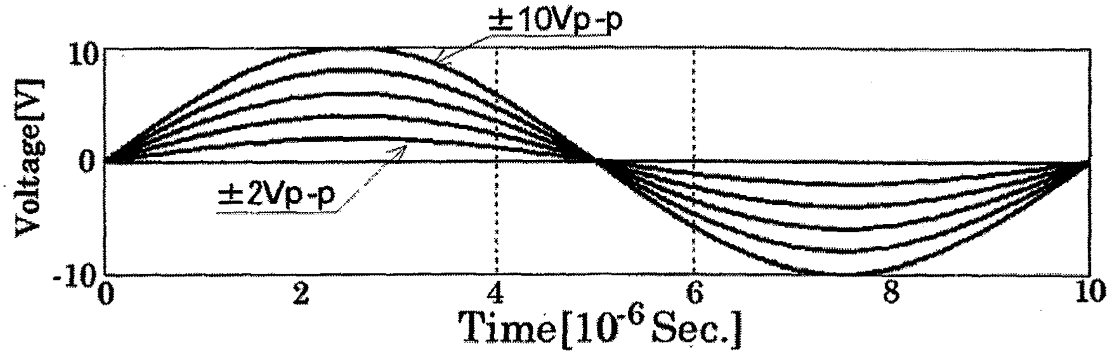


*Fig. 39 B*

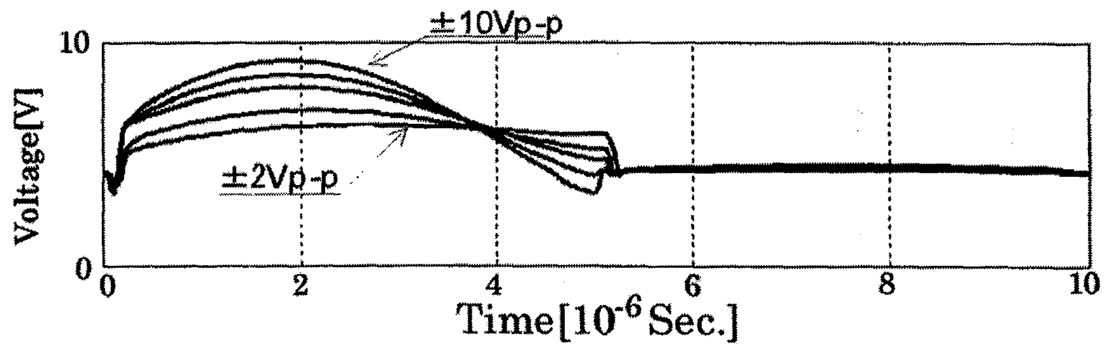


*Fig. 39 C*

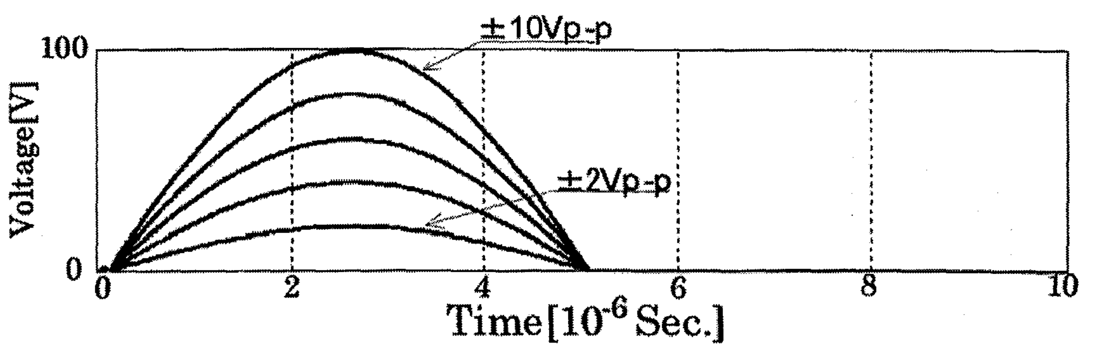

*Fig. 39 D*

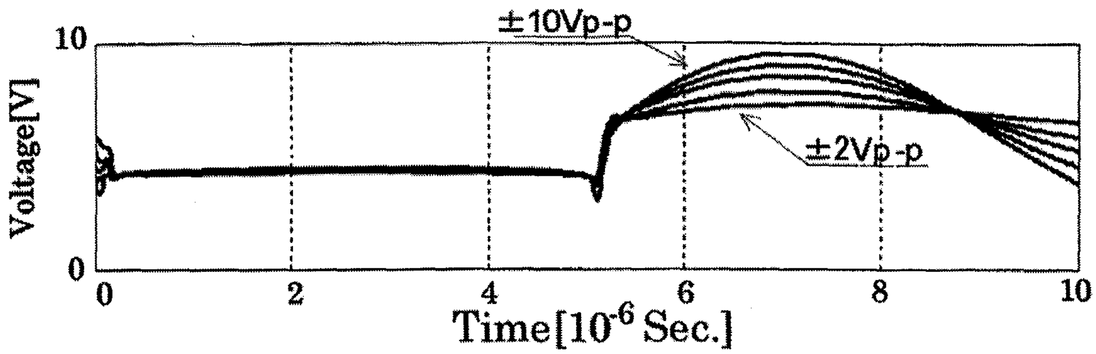


*Fig. 39 E*

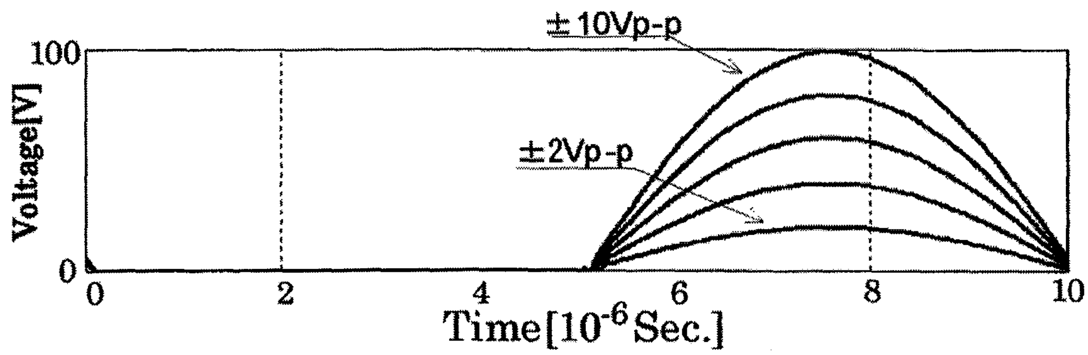


*Fig. 39 F*

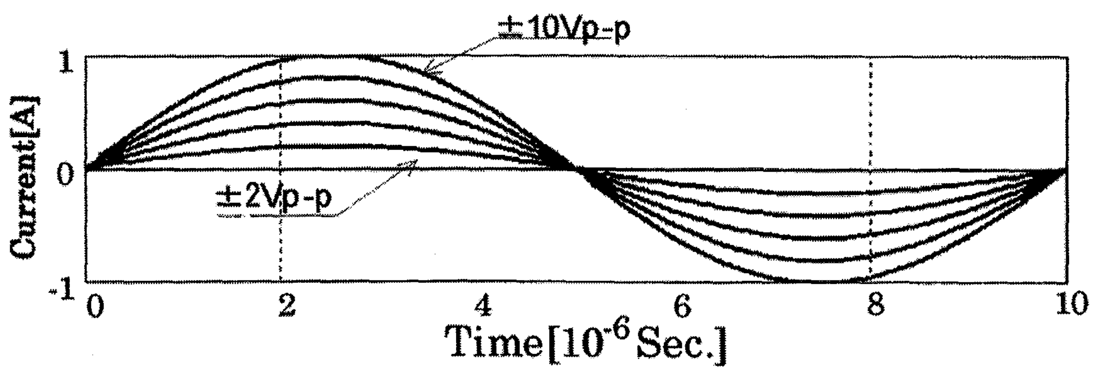

*Fig. 40*

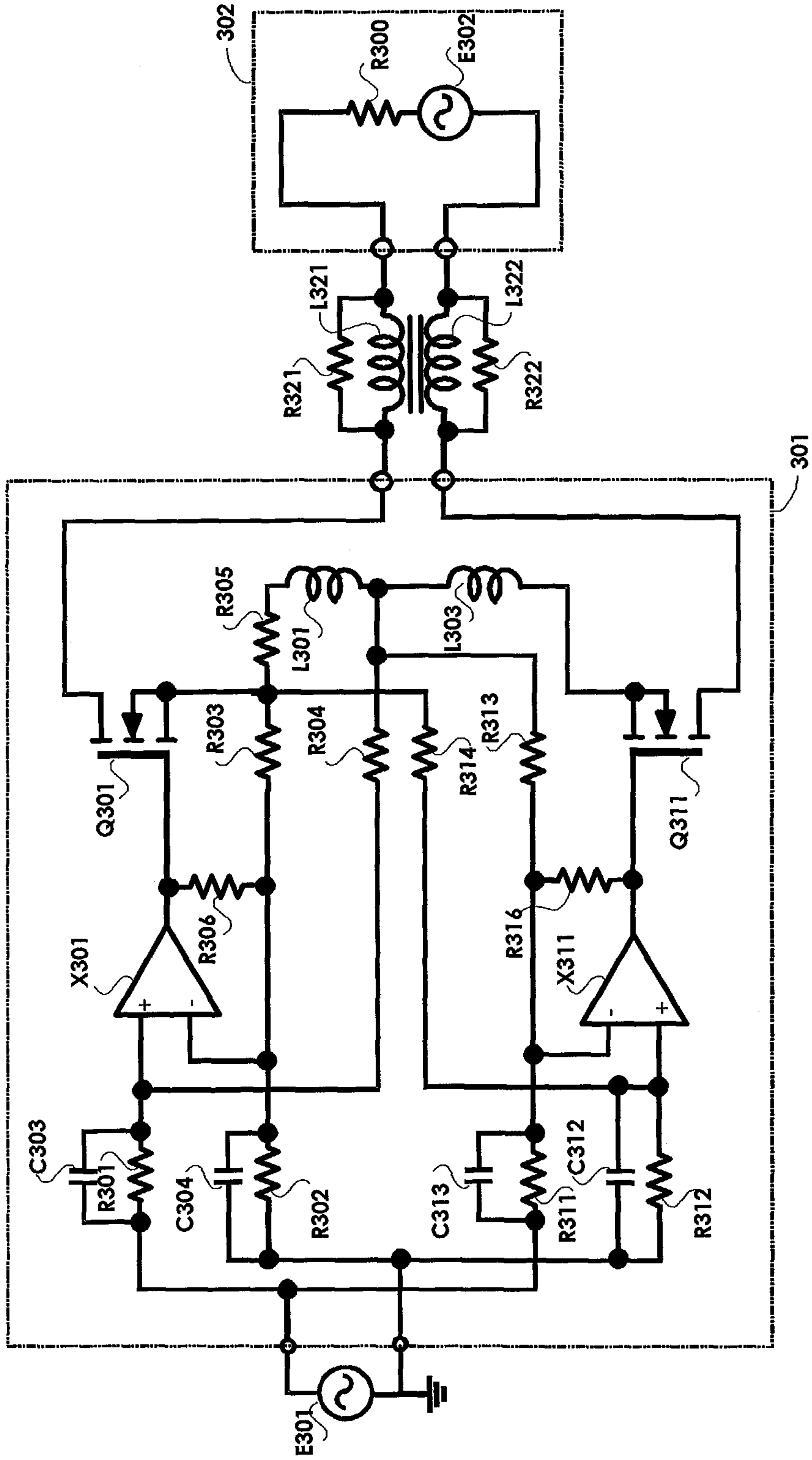
302
R300
E302
L321
L322
R321
R322
301
R305
L301
L303
R303
R304
R314
R313
Q301
Q311
R306
X301
R316
X311
C303
R301
C304
R302
C313
R311
C312
R312
E301

*Fig. 41 A*

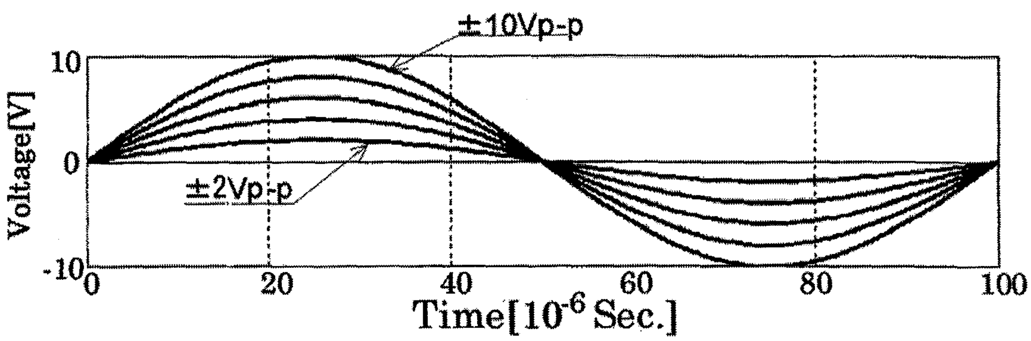


*Fig. 41 B*

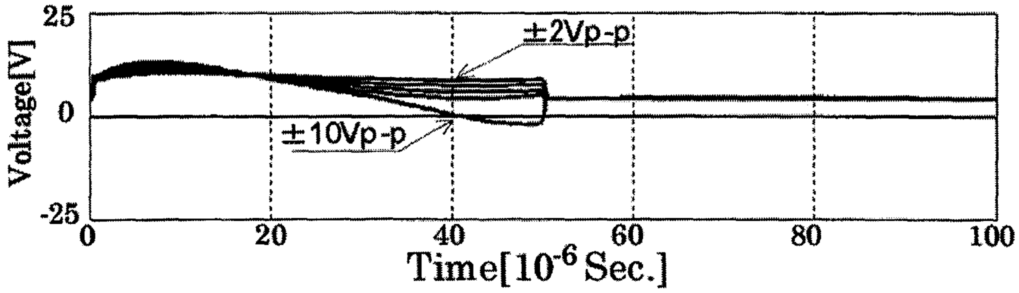


*Fig. 41 C*

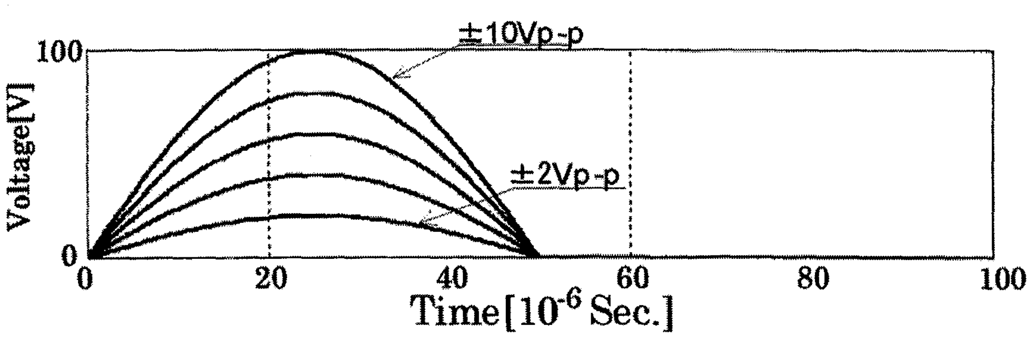

*Fig. 41 D*

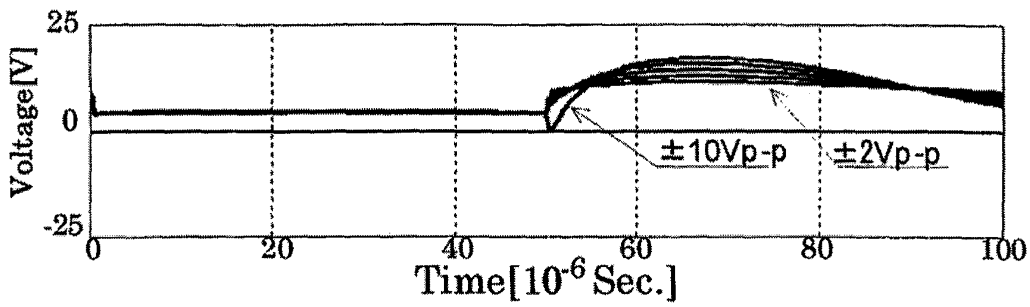


*Fig. 41 E*

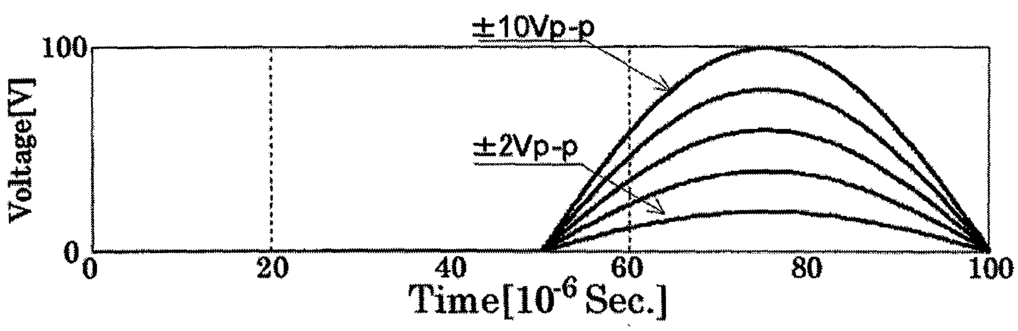


*Fig. 41 F*

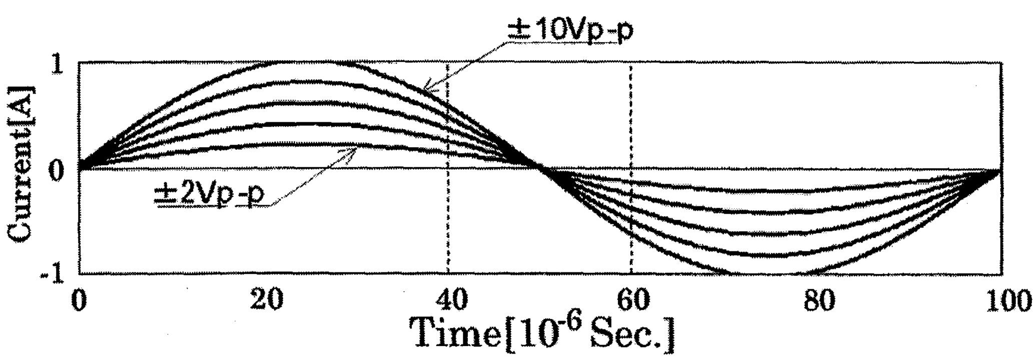

*Fig. 42*

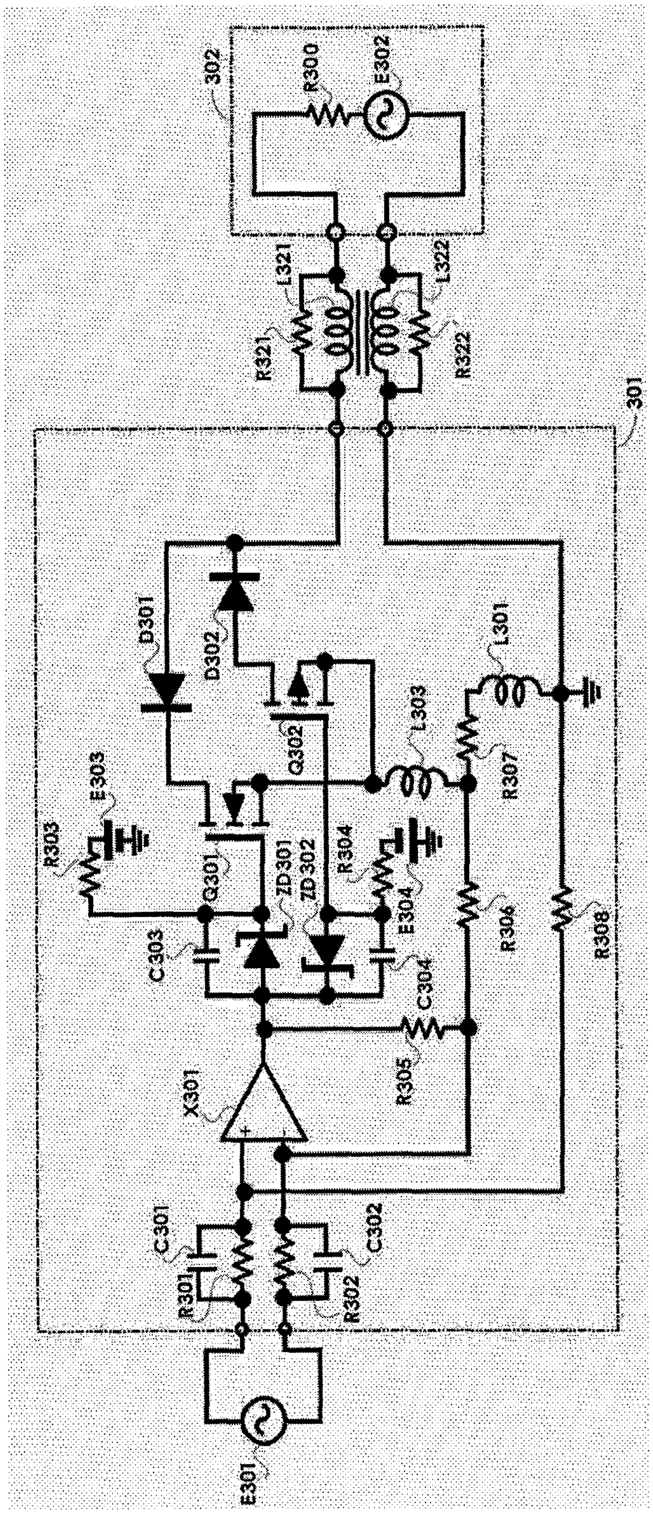
302
R300
E302
L321
L322
R321
R322
301
D301
D302
Q302
L301
L303
R307
E303
R303
Q301
ZD301
ZD302
R304
E304
C303
C304
R306
R308
R305
X301
C301
C302
R301
R302
E301

*Fig. 43 A*

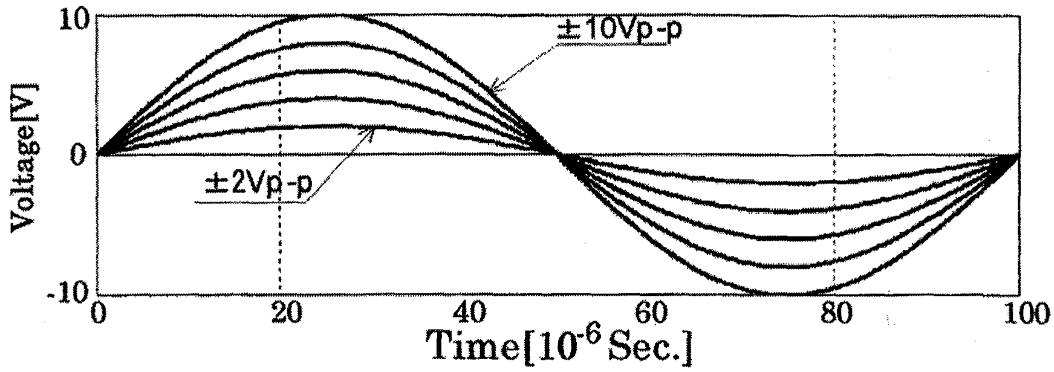


*Fig. 43 B*

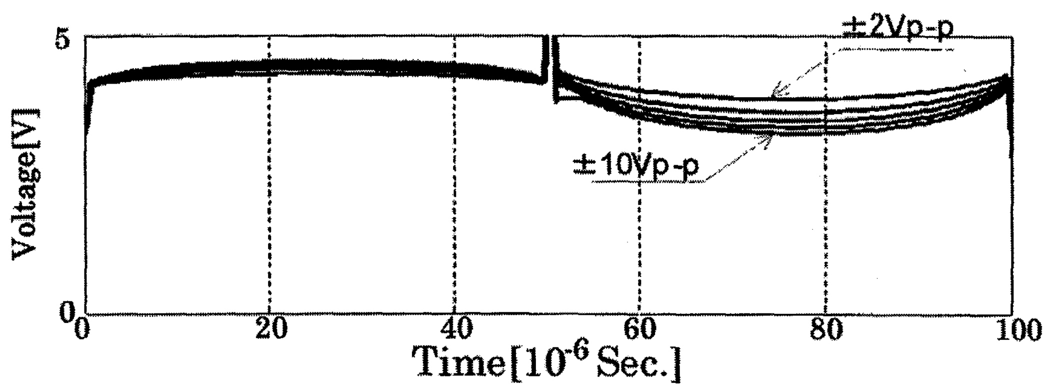


*Fig. 43 C*

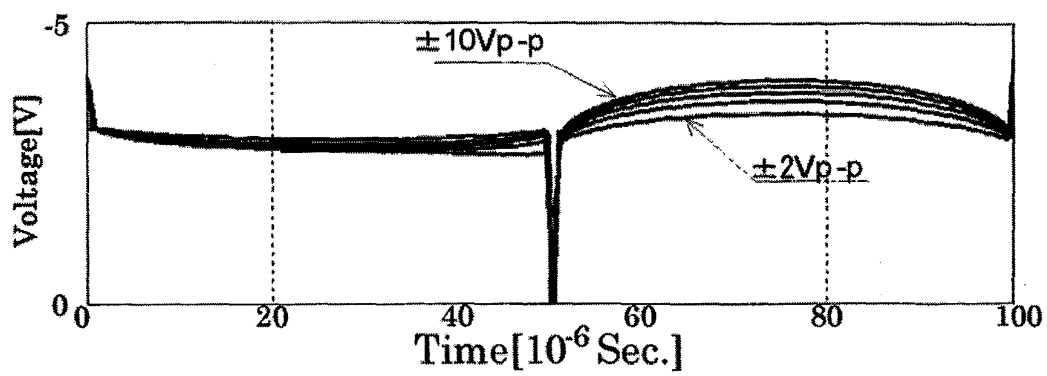

*Fig. 43 D*